(19) Europäisches Patentamt

European Patent Office

Office européen des brevets

(11) **EP 4 535 663 A1**

(12) **EUROPEAN PATENT APPLICATION**

(43) Date of publication:
09.04.2025 Bulletin 2025/15

(21) Application number: 24196076.4

(22) Date of filing: 23.08.2024

(51) International Patent Classification (IPC):
*H03H 19/00* (2006.01)

(52) Cooperative Patent Classification (CPC):
H03H 19/002

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 25.09.2023 US 202318372604

(71) Applicant: **INTEL Corporation**
**Santa Clara, CA 95054 (US)**

(72) Inventor: **KRISHNAMURTHY, Sashank**
**Hillsboro, 97124 (US)**

(74) Representative: **2SPL Patentanwälte PartG mbB**
**Landaubogen 3**
**81373 München (DE)**

(54) **METHODS AND ARRANGEMENTS FOR AN N-PATH FILTER USING A FOURTH ORDER ALL POLE DRIVING POINT IMPEDANCE**

(57)     Embodiments may comprise N-path filter circuitry with tunable radio frequency selectivity and up to 80 decibels per decade roll-off. The N-path filter may comprise at least one input transistor, wherein the at least one input transistor comprises a channel and a gate. A first end of the channel is coupled with a receiver circuitry input, wherein a second end of the channel is coupled with a load. The gate of the at least one input transistor is coupled with a clock circuitry input. The load may comprise a fourth order, all-pole driving point impedance. The impedance may shunt the second end of the channel to a circuit ground or a low voltage circuit rail via the impedance. And the impedance may comprise a first active impedance circuit coupled in series with a second active impedance circuit.

FIG. 2A

**Description**

## TECHNICAL FIELD

This disclosure generally relates to methods and arrangements for an n-path filter and, more particularly, to an n-path filter with a fourth order all pole driving point impedance.

## BACKGROUND

The ever-increasing demand for wireless data rates advocates higher order modulations schemes and increases in spectral efficiency. The demand has led to a proliferating number of bands in the sub-6-GHz regime and communications, residing in the same frequency band and/or in an adjacent frequency band, causing multiple access interference (MAI), cross talk, and leakage. In such situations, a receiver may capture energy not only from a signal being received, but also energy as interference from the adjacent channels. The interference can cause distortion in the signal received by the receiver. If the receiver encounters too much distortion, the bit error rate (BER) and the packet error rate (PER) increases, causing packet losses. Packet losses may cause retransmissions of the packets, reducing the spectral efficiency.

The demand has also led to growing requirements for highly linear front ends that are resilient to interferences both in adjacent and far-out channels. Recently, multi-carrier schemes have been proposed to increase the throughput from a given device. For instance, WiFi Triple Band Concurrency (TBDC) and Single band Multi Carrier (SMC) schemes allow two simultaneous asynchronous links at any two channels in the 2.4-2.5GHz and 5-7GHz bands from a single device that share the same antenna infrastructure. Since two transceivers share the same antenna at different channels, possibly in the same frequency band, the incidence of cross talk and leakage of the transmitter (TX) signal from one stream to the other stream receiver (RX), whether as an out-of-channel (OOC) blocker or in-channel noise, has increased.

As a result, the traditional solution of highly selective but bulky and nontunable SAW filters is becoming untenable for a large number of bands. With an increasingly crowded spectrum, extending the existing solutions by having more surface acoustic wave filter (SAW) /thin-film bulk acoustic resonator (FBAR) filters may not be feasible for a multitude of reasons, from the non-availability of such filters operating beyond a few gigahertz to the increased area footprint of these filters.

## BRIEF DESCRIPTION OF THE DRAWINGS

FIG. 1A illustrates an embodiment of N-path filter circuitry at an output of a low noise amplifier (LNA).

FIG. 1B illustrates an embodiment of 25% duty cycle pulses of the clock signal from a local oscillator (LO).

FIG. 1C illustrates an embodiment of part of a front-end module for a passive, mixer-first receiver.

FIG. 1D illustrates an embodiment of a fourth order driving point impedance.

FIG. 1E illustrates an embodiment of a circuit to implement the negative inductance (-L1).

FIG. 1F illustrates an embodiment of a circuit to implement the parallel combination of the negative resistance (-R1) and the negative capacitance (-C1).

FIG. 1G illustrates an embodiment of a simulation for the fourth order driving point impedance.

FIG. 1H illustrates an embodiment of a simulation of a baseband low-pass response of the bandpass transfer function from the simulation shown in FIG. 1G.

FIG. 2A depicts an embodiment of a system to implement N-path filter circuitry and baseband shunt-feedback amplifiers shown in FIGs 1A-1C.

FIG. 2B illustrates an embodiment of a block diagram of a radio architecture such as the wireless interfaces shown in FIG. 2A.

FIG. 2C illustrates an embodiment of front-end module (FEM) circuitry such as wireless local area network (WLAN) FEM circuitry and the Bluetooth® (BT) FEM circuitry shown in FIG. 2B.

FIG. 2D illustrates an embodiment of radio IC circuitry such as the radio IC circuitry in FIG. 2B.

FIGS. 2E and 2F illustrate alternative embodiments of FEM circuitry and radio IC circuitry such as the circuitry shown in FIGs. 2A-2D.

FIG. 2G illustrates an embodiment of a functional block diagram of baseband processing circuitry.

FIG. 3 depicts an embodiment of an apparatus to generate, transmit, receive, and interpret or decode physical layer (PHY) frames and medium access control (MAC) layer frames.

FIG. 4 depicts an embodiment of a flowchart of a process to implement N-path filter circuitry such as the N-path filter circuitry discussed in FIGs. 1-3.

FIG. 5 shows an embodiment of a functional diagram of a communication station.

FIG. 6 illustrates a block diagram of an example of a machine or system.

FIG. 7 illustrates an example of a storage medium to store code and data.

FIG. 8 illustrates an example computing platform.

FIG. 9 illustrates example components of a device such as base stations and user equipment (UEs) shown in FIG. 11.

FIG. 10A illustrates an embodiment of communication circuitry such as the circuitry in the access nodes (ANs) and the user equipment (UE) shown in FIG. 11.

FIG. 10B illustrates an embodiment of radio frequency circuitry in FIG. 10A such as a RF circuitry or radio illustrated in FIGs. 1A-H, 2A-2B, 3, 5-6, and 9.

FIG. 11 illustrates an embodiment of an architecture of a system of a cellular network.

FIG. 12 illustrates example interfaces of baseband circuitry such as the baseband circuitry shown in FIGs. 2A, 2B, 2G, 3, and 9.

## DETAILED DESCRIPTION OF EMBODIMENTS

The following description and the drawings sufficiently illustrate specific embodiments to enable those skilled in the art to practice them. Other embodiments may incorporate structural, logical, electrical, process, algorithm, and other changes. Portions and features of some embodiments may be included in, or substituted for, those of other embodiments. Embodiments set forth in the claims encompass all available equivalents of those claims.

A conventional passive N-path filter/mixer consists of an N-path filter with a first order shunt resistive-capacitive (RC) load. Due to the bidirectionality and impedance translational properties of the N-path filter, this yields first order radio frequency (RF) bandpass filtering centered at the frequency of a local oscillator (fLO). Higher order RF bandpass filters may be synthesized by loading the N-path filter with a higher-order driving point impedance.

Embodiments may implement a novel higher-order N-path filter loaded by a fourth order all-pole driving point impedance (also referred to herein as N-path filter circuitry) to provide fourth order RF filtering of both internal and external blockers. Many embodiments may provide an N-path filter with 80 decibels per decade (dB/decade) radio frequency (RF) selectivity using a fourth-order all-pole driving point impedance. Many embodiments advantageously have very high linearity and blocker tolerance.

TBDC and SMC solutions today require very area intensive filtering techniques like BAW filters at 5GHz, which restricts the choice of channels for communications. Many embodiments described herein have relatively reduced area requirements (in silicon area or other substrate area) and advantageously increase channels available for, e.g., TBDC and SMC solutions.

Note that the N-path filter circuitry described herein has multiple applications so embodiments of usage models described herein are not restricted to the limited number of embodiments that can be described herein. For wireless communications, embodiments may implement N-path filter circuitry in cellular communications, Bluetooth® communications, WiFi communications, and/or the like. Such embodiments may advantageously reduce the complexity and silicon area requirements for filtering noise from incoming communication signals.

In many embodiments, the N-path filter circuitry may comprise a fourth order N-path filter using an N-path filter loaded by an active fourth order all-pole driving point impedance. In some embodiments, a synthesized fourth order N-path filter is at the output of a low noise amplifier (LNA). In some embodiments, the synthesized fourth order N-path filter is at a passive mixer-first receiver. In many embodiments, the location of the N-path filter circuitry may vary based on system sensitivity specifications. The down-converted baseband output of the N-path filter circuitry, which has a filtering profile of up to 80dB/decade, may, in some embodiments, be amplified by a baseband shunt-feedback amplifier to reduce distortion and increase linearity.

The N-path filter circuitry may comprise an analog input for a communication signal from an antenna or a LNA in some embodiments. The analog input may couple, in parallel with one or more N-path filters having an active load shunted to a circuit ground or a circuit low voltage rail. A circuit ground may comprise a ground or a floating ground. And the output of the one or more N-path filters may couple with an input of one or more baseband shunt-feedback amplifiers. In some embodiments, one or more components may reside between the N-path filters and the baseband shunt-feedback amplifiers. In other embodiments, the baseband amplifiers may not be baseband shunt-feedback amplifiers.

The active load may comprise a fourth order all-pole driving point impedance. The fourth order all-pole driving point impedance may comprise a series combination of two active impedances coupled in parallel with a shunt impedance. In other embodiments, the shunt impedance may be incorporated into the series combination of two active impedances. The series combination of two active impedances may comprise a first impedance, $Z_{2a}(s)$, which may include one or more active impedance circuits and a second impedance, $Z_{2b}(s)$, which may include one or more active, negative impedance circuits. The shunt impedance may comprise a circuit comprising one or more resistors coupled in parallel with one or more capacitors.

A first impedance, $Z_{2a}(s)$, may comprise one or more amplifiers (or operational amplifiers), $g_m$, coupled in parallel with one or more capacitors, $C_1$. The one or more amplifiers, $g_m$, may comprise one or more resistors coupled between a source and a gate of one or more transistors and one or more capacitors, $C_s$, coupled between the gate and the drain of the one or more transistors. In some embodiments, the transistors may comprise field effect transistors (FETs) such as n-channel metal oxide semiconductor FETs (MOSFETs) and/or p-channel MOSFETs.

The second impedance, $Z_{2b}(s)$, may comprise a negative impedance circuit with that may represented as an equivalent circuit such as a negative inductance, -Li, in parallel with a negative resistance, -Ri, and in parallel with a negative capacitance, -Ci. In some embodiments, the negative inductance, -Li, may comprise a negative inductance circuit such as a differential negative inductance -L that is a gm-C gyrator with differential mode positive feedback. The negative RC impedance may comprise a negative resistance-capacitance circuit, -RC circuit, implemented by coupling one or more resistors and one or more capacitors in a positive feedback loop about an amplifier of gain A with a negative output resistance. With appropriate biasing, the negative RC impedance circuit also cancels distortion generated by the amplifier, which may comprise, e.g., four or more transistors, M1 through M4, coupled to a circuit ground via bias circuitry.

Note that many embodiments illustrated herein describe discrete elements in circuits or circuitry. However, any of or all the circuit elements discussed herein may be implemented in on a semiconductor in integrated circuits (ICs), as discrete elements on a printed circuit board (PCB), or any combination of one or more discrete elements and one or more integrated circuits. In some embodiments, one or more integrated circuits may be packaged in a single chip package or in two or more chip packages.

Furthermore, while an embodiment may illustrate a single discrete circuit element such as a resistor, a capacitor, an inductor, a transistor, and/or the like, such embodiments may comprise any equivalent configuration of discrete circuit elements or circuit elements implemented on an integrated circuit. For instance, embodiments comprising a capacitance may be illustrated as a discrete circuit element (a capacitor), but such embodiments may implement the capacitance as one or more capacitances or capacitors coupled in parallel and/or coupled in series, or as one or more transistor circuits configured to have an equivalent capacitance under operating conditions. Embodiments of a resistance may illustrate the resistance as a discrete circuit element (a resistor), but such embodiments may implement the resistance as one or more resistances or resistors coupled in parallel and/or coupled in series, or as one or more transistor circuits configured to have an equivalent resistance under operating conditions. Embodiments of an inductance may illustrate the inductance as a discrete circuit element (an inductor), but such embodiments may implement the inductance as one or more inductances or inductors coupled in parallel and/or coupled in series, or as one or more transistor circuits configured to have an equivalent inductance under operating conditions. Embodiments of a transistor may illustrate the transistor as a discrete circuit element, but such embodiments may implement the transistor as one or more transistors coupled in parallel and/or coupled in series. Furthermore, embodiments that implement an amplifier with one or more transistors may alternatively be implemented with one or more discrete operational amplifier elements or one or more operational amplifiers coupled in series and/or in parallel.

Embodiments may also be stations (STAs) comprising N-path filter circuitry to facilitate communications in accordance with different versions of Institute of Electrical and Electronics Engineers (IEEE) 802.11 standards for wireless communications (generally referred to as "Wi-Fi") such as IEEE 802.11-2020, December 2020; IEEE P802.11be™/D2.2, October 2022; IEEE P802.11ax-2021™, IEEE P802.11ay-2021™, IEEE P802.11az™/D3.0, IEEE P802.11ba-2021™, IEEE P802.11bb™/D0.4, IEEE P802.11bc™/D1.02, and IEEE P802.11bd™/D1.1.

The techniques disclosed herein may involve inclusion of N-path filter circuitry in communication of data over one or more wireless connections using one or more wireless mobile broadband technologies. For example, various embodiments may involve communications over one or more wireless connections according to one or more 3rd Generation Partnership Project (3GPP), 3GPP Long Term Evolution (LTE), 3GPP LTE-Advanced (LTE-A), 4G LTE, 5G New Radio (NR) and/or 6G, technologies and/or standards, including their revisions, progeny and variants. Various embodiments may additionally or alternatively involve transmissions according to one or more Global System for Mobile Communications (GSM)/Enhanced Data Rates for GSM Evolution (EDGE), Universal Mobile Telecommunications System (UMTS)/High Speed Packet Access (HSPA), and/or GSM with General Packet Radio Service (GPRS) system (GSM/GPRS) technologies and/or standards, including their revisions, progeny and variants.

Examples of wireless mobile broadband technologies and/or standards may also include, without limitation, any of the Institute of Electrical and Electronics Engineers (IEEE) 802.16 wireless broadband standards such as IEEE 802.16m and/or 802.16p, International Mobile Telecommunications Advanced (IMT-ADV), Worldwide Interoperability for Microwave Access (WiMAX) and/or WiMAX II, Code Division Multiple Access (CDMA) 2000 (e.g., CDMA2000 1xRTT, CDMA2000 EV-DO, CDMA EV-DV, and so forth), High Performance Radio Metropolitan Area Network (HIPERMAN), Wireless Broadband (WiBro), High Speed Downlink Packet Access (HSDPA), High Speed Orthogonal Frequency-Division Multiplexing (OFDM) Packet Access (HSOPA), High-Speed Uplink Packet Access (HSUPA) technologies and/or standards, including their revisions, progeny and variants.

The above descriptions are for purposes of illustration and are not meant to be limiting. Numerous other examples, configurations, processes, algorithms, etc., may exist, some of which are described in greater detail below. Example embodiments will now be described with reference to the accompanying figures.

Various embodiments may be designed to address different technical problems associated with filtering schemes. Current filtering may involve analog baseband gm-C filters after the LNA gain that amplify the signal but also in band blockers, which eventually limits the performance of the multi-channel. Current filtering may involve a passive cascade of N-path filters that incurs an insertion loss and need higher local oscillator (LO) power to drive more mixer switches needed for multiple N-path filters. Any phase mismatch between the LO driving the multiple N-path filters and the carrier frequency of the incoming wireless communication signal can lead to further insertion loss. Current filtering may involve higher-order N-path filter implementations that have limited RF selectivity, which does not match the superior selectivity offered by existing bulk acoustic wave (BAW) filter solutions.

Different technical problems such as those discussed above may be addressed by one or more different embodiments. Embodiments may address one or more of these problems associated with filtering schemes. For instance, some embodiments that address problems associated with filtering schemes may do so by one or more different technical means, such as, N-path circuitry comprising at least one input transistor, wherein the at least one input transistor comprises a channel and a gate. A first end of the channel is coupled with a receiver circuitry input. A second end of the channel is coupled with a load, wherein the gate of the at least one input transistor is coupled with a clock circuitry input. The load may comprise a fourth order, all-pole driving point impedance, the impedance to shunt the second end of the channel to a circuit ground or a low voltage circuit rail via the impedance. The impedance may comprise a first active impedance circuit coupled in series with a second active impedance circuit. The first active impedance circuit may comprise a first active impedance transistor coupled in parallel with a first capacitance, wherein the first active impedance transistor comprises a first resistance coupled between a source and a gate of the first active impedance transistor and a second capacitance coupled between the gate and a drain of the first active impedance transistor. The second active impedance circuit may have a transfer function equivalent to a parallel combination of a negative resistance, a negative inductance, and a negative capacitance.

Several embodiments comprise central servers, access points (APs), and/or stations (STAs) such as modems, routers, switches, servers, workstations, netbooks, mobile devices (Laptop, Smart Phone, Tablet, and the like), sensors, meters, controls, instruments, monitors, home or office appliances, Internet of Things (IoT) gear (watches, glasses, headphones, and the like), and the like. Some embodiments may provide, e.g., indoor and/or outdoor "smart" grid and sensor services. In various embodiments, these devices relate to specific applications such as healthcare, home, commercial office and retail, security, and industrial automation and monitoring applications, as well as vehicle applications (automobiles, self-driving vehicles, airplanes, and the like), and the like.

Some embodiments may facilitate wireless communications in accordance with multiple standards. Some embodiments may comprise low power wireless communications like Bluetooth®, cellular communications, and messaging systems. Furthermore, some wireless embodiments may incorporate a single antenna while other embodiments may employ multiple antennas or antenna elements.

While some of the specific embodiments described below will reference the embodiments with specific configurations, those of skill in the art will realize that embodiments of the present disclosure may advantageously be implemented with other configurations with similar issues or problems.

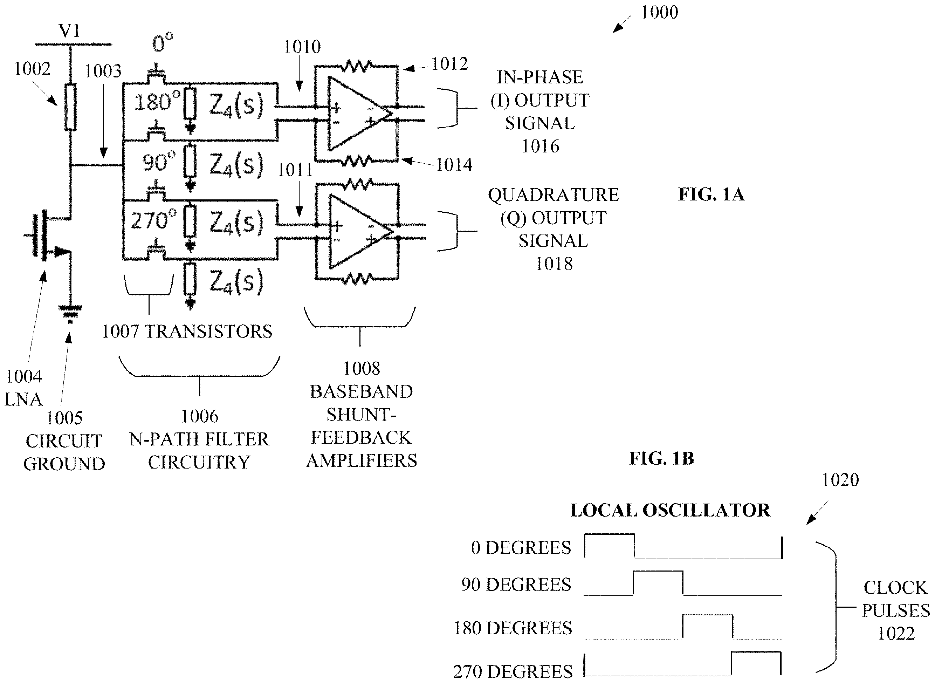

**FIGs. 1A-1C** depict embodiments of circuitry to implement N-path filter circuitry 1006 in a wireless receiver radio integrated circuit 1000 for, e.g., a user equipment (UE), a WiFi station (STA), a Bluetooth® device, or the like. The N-path filter circuitry 1006 may improve reception of a communication signal by blocking multiple access interference (MAI), cross talk, leakage, as well as canceling or attenuating distortion associated with operation of transistors in the active, fourth order all-pole driving point impedance, $Z_4(s)$, of the N-path filter circuitry 1006.

FIG. 1A illustrates an embodiment of N-path filter circuitry 1006 at an output of a LNA 1004. The LNA 1004 may have a source coupled with a voltage circuit rail, V1, via an impedance such as a resistance 1002 and may have a drain coupled with a circuit ground 1005 or low voltage rail. The N-path filter circuitry 1006 may couple with an output of the LNA 1004 between the source of the LNA 1004 and the resistance 1002. The output of the LNA 1004 is an amplified analog input signal 1003 based on energy received by an antenna (not shown) coupled with the radio IC 1000.

In the present embodiment, the input of the N-path filter circuitry 1006 couples with four parallel N-path filters including a 0-degree filter, an 180-degree filter, a 90-degree filter, and a 270 degrees filter. The input signals 1003 are applied to the channels of input transistors 1007 such as field effect transistors (FETs) to selectively apply the input signals 1003 to the driving point impedances $Z_4(s)$ based on clock pulses 1022 from a local oscillator (LO) 1020 shown in FIG. 1B.

The gate of each input transistor 1007 is coupled with the LO 1020 to receive, e.g., 25% duty cycle clock pulses 1022 of the clock signal from the LO 1020 as shown in FIG. 1B, where the 0 degree clock pulse is applied to the gate of the input transistor 1007 for the 0 degree N-path filter, the 90 degree clock pulse is applied to the gate of the input transistor 1007 for the 90 degree N-path filter, the 180 degree clock pulse is applied to the gate of the input transistor 1007 for the 180 degree N-path filter, and the 270 degree clock pulse is applied to the gate of the input transistor 1007 for the 270 degree N-path filter. Note that embodiments may include, for any integer N, an N-path filter with N filters branches, each of which driven by a 100/N% duty-cycled non-overlapping LO clock signal.

During the application of the LO 1020 clock pulses 1022 to the gates of the input transistors 1007 of the 0 degree N-path filter, the 90 degree N-path filter, the 180 degree N-path filter, and the 270 degree N-path filter, current may flow through the channels of the input transistors 1007 to the loads of the respective input transistors 1007, which are the driving point impedances $Z_4(s)$. As a result, each N-path filter, in such embodiments, may allow one fourth of the period of the input signal 1003 from the LNA 1004 to shunt to circuit ground 1005 via the respective driving point impedances $Z_4(s)$ connected to opposite side of the channel of the input transistors 1007 from the input signal 1003. For example, the input signal 1003 at the channel of the 0-degree N-path filter may flow through the channel of the 0 degree transistor 1007 during the 0 degree clock pulse 1022 of the LO 1020 to the 0 degree driving point impedance $Z_4(s)$ coupled with the opposite side of the channel of the 0 degree input transistor 1007. The input signal 1003 at the 90-degree N-path filter may flow through the channel of the 90-degree transistor 1007 during the 90-degree clock pulse 1022 of the LO 1020 to the 90-degree driving point impedance $Z_4(s)$ coupled with the opposite side of the channel of the 90-degree input transistor 1007. The input signal at the 180-degree N-path filter may flow through the channel of the 180-degree transistor 1007 during the 180-degree clock pulse 1022 of the LO 1020 to the 180-degree driving point impedance $Z_4(s)$ coupled with the opposite side of the channel of the 180-degree input transistor 1007. And the input signal at the 270-degree N-path filter may flow through the channel of the 270-degree input transistor 1007 during the 180-degree clock pulse 1022 of the LO 1020 to the 270-degree driving point impedance $Z_4(s)$ coupled with the opposite side of the channel of the 270-degree input transistor 1007.

While the LO 1020 is at a low circuit voltage (not during the clock pulse 1022) the channels of the input transistors 1007 (ideally) may not allow the input signal 1003 to cross the channels of the input transistors 1007 to the side of the channel coupled with the driving point impedances $Z_4(s)$ of each of the N-path filters. Furthermore, each of the clock pulses cover different portions of the period of the carrier frequency. Thus, in the present embodiment, the combination of all the N-path filters in the N-path filter circuitry 1006 passes the entire input signal 1003 to the respective loads but each individual N-path filter load may only receive energy from the wireless communication signal during one fourth of a clock cycle (clock period of the LO 1020) of the input signal 1003.

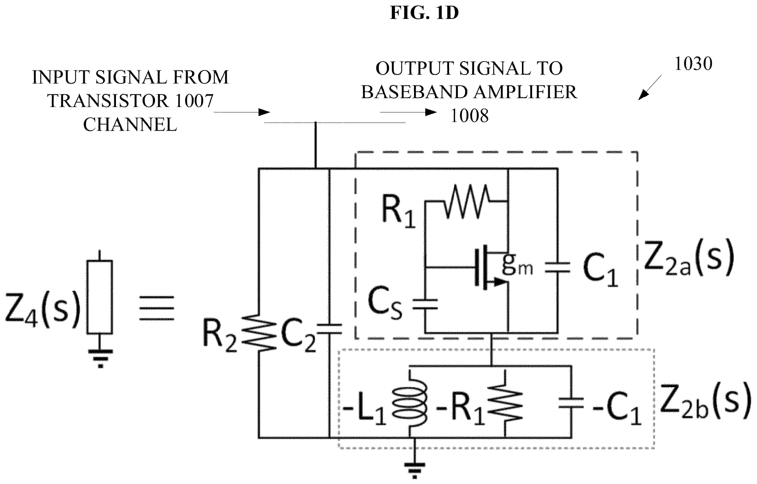

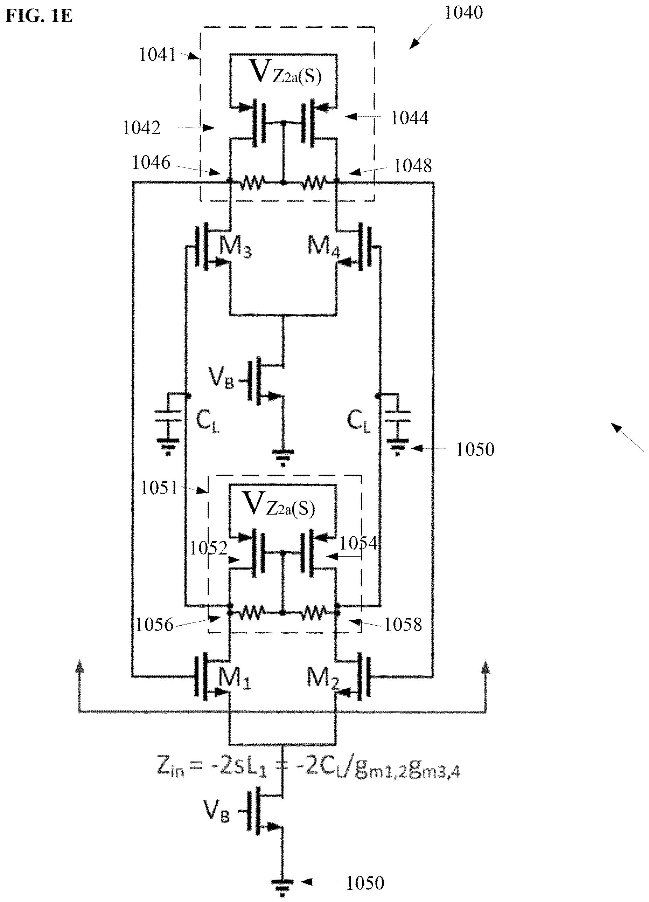

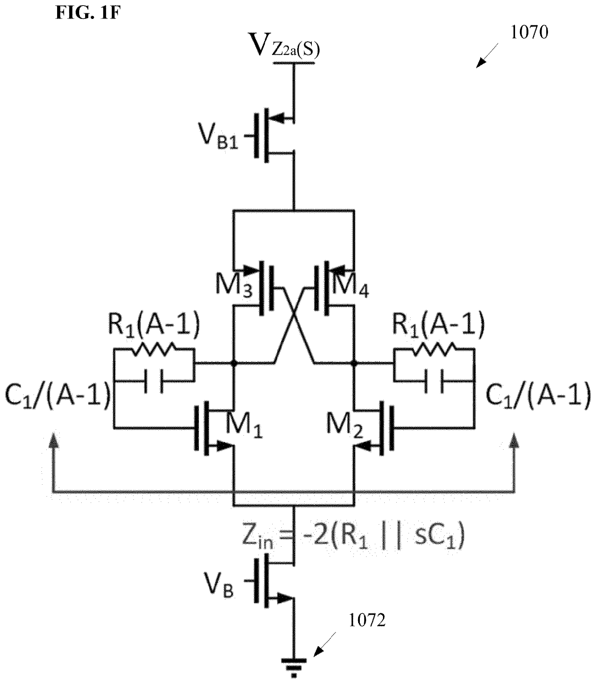

The LO 1020 can be set to the frequency of the carrier wave of incoming communication signal or the input signal 1003 output by the LNA 1004, allowing the driving point impedances $Z_4(s)$ to shunt the input signal 1003 to the circuit ground 1005. The driving point impedances $Z_4(s)$ are illustrated and discussed in conjunction with FIGs. 1D, 1E, and 1F.

The driving point function is the ratio of Laplace transform of the source voltage and source current. The driving point impedances $Z_4(s)$ capture energy from the portions of the input signal 1003 that flow through each of the driving point impedances $Z_4(s)$. The energy captured by the driving point impedances $Z_4(s)$ from communication signals having frequencies other than the frequency of the LO 1020 may average as zero energy or approximately zero energy, advantageously allowing the N-path filter circuitry 1006 to act as a narrow bandpass filter with up to an 80 decibel (dB) per decade roll-off and to be tunable based on the frequency of the LO 1020.

The output 1010 of the N-path filter circuitry 1006 from the 0-degree N-path filter and the 180-degree N-path filter may couple with the positive and negative inputs, respectively, of a first baseband shunt-feedback amplifier 1008 and may comprise an in-phase (I) signal. The output 1011 of the N-path filter circuitry 1006 from the 90-degree N-path filter and the 270-degree N-path filter may couple with the positive and negative inputs, respectively, of a second baseband shunt-feedback amplifier 1008 and may comprise a quadrature (Q) signal. Note that the assignment of the I and Q to signals output by the N-path filter may be reversed in some embodiments. Note also that, in some embodiments, additional circuit components may reside between the N-path filter circuitry 1006 and the baseband shunt-feedback amplifiers 1008.

The baseband shunt-feedback amplifiers 1008 may amplify the I and Q signals prior to conversion of the signals from analog to digital via analog to digital converters (ADCs) (not shown) of the radio IC 1000 or of a baseband processing circuitry such as a baseband processor (not shown). In some embodiments, the baseband shunt-feedback amplifiers 1008 may output the I and Q output signals 1016 and 1018 to low-pass filters (not shown) and the low-pass filters may output the I and Q output signals as I and Q input signals to ADCs of the radio IC 1000 or as I and Q input signals to a baseband processor.

In some embodiments, the baseband shunt-feedback amplifiers 1008 may comprise negative feedback 1012 and 1014 to reduce distortion and increase linearity of the I and Q input signals. In some embodiments, the negative feedback may include a positive output of a baseband shunt-feedback amplifier 1008 coupled with a negative input of the baseband shunt-feedback amplifier 1008 via an impedance such as a resistor or a resistance. The negative feedback also may include a negative output of the baseband shunt-feedback amplifier 1008 coupled with a positive input of the baseband shunt-feedback amplifier 1008 via an impedance such as a resistor or a resistance. In many embodiments, the positive feedback and the negative feedback include the same impedance. In other embodiments, the baseband shunt-feedback amplifiers 1008 may comprise baseband amplifiers without feedback, with positive feedback, with feedback having a different impedance configuration, or with different feedback configurations for the positive and negative inputs of the baseband amplifiers.

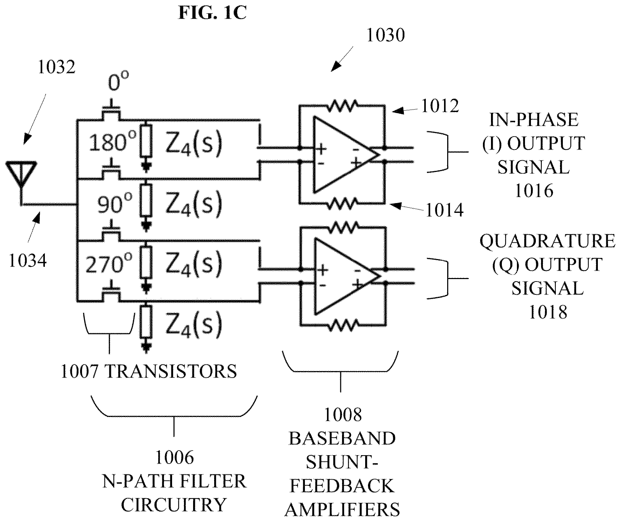

FIG. 1C illustrates an embodiment of part of a front-end module 1030 for a passive, mixer-first receiver. In the present embodiment, an antenna 1032 captures energy of an incoming communication signals 1034. The output of the antenna may couple with the input of the N-path filter circuitry 1006. The N-path filter circuitry 1006 may operate in the same manner as the N-path filter circuitry discussed in conjunction with FIG. 1A but operate on the incoming communication signal 1034 rather than the amplified output of a LNA. The outputs of the N-path filter circuitry 1006 may comprise I and Q signals and may couple with the inputs of the baseband shunt-feedback amplifiers 1008. The outputs of the baseband shunt-feedback amplifiers 1008 may comprise analog I and Q output signals 1016 and 1018 and may couple with the inputs of an I mixer and a Q mixer, respectively.

FIG. 1D illustrates an embodiment of a fourth order driving point impedance $Z_4(s)$ such as the fourth order driving point impedance $Z_4(s)$'s shown in FIGs. 1A and 1C. The fourth order driving point impedance $Z_4(s)$ may comprise an input to receive an input signal from a channel of an input transistor 1007 of an N-path filter such as the 0 degree N-path filter, the 90 degree N-path filter, the 180 degree N-path filter, or the 270 degree N-path filter shown in FIGs. 1A and 1C. The output of the N-path filter is coupled with the input of the driving point impedance $Z_4(s)$ and coupled with a baseband amplifier such as the baseband shunt-feedback amplifier 1008 shown in FIGs. 1A and 1C.

The fourth order driving point impedance $Z_4(s)$ may comprise a resistance or resistor R2 coupled in parallel with a capacitance or capacitor C2 and coupled in parallel with a series combination of impedances $Z_{2a}(s)$ and $Z_{2b}(s)$, given by:

$$Z_{2a}(s) + Z_{2b}(s) = \frac{1+sR_1C_S}{g_m\left(1+\frac{s(C_S+C_1)}{g_m}+\frac{s^2C_1C_SR_1}{g_m}\right)} - \frac{sL_1}{1+\frac{sL_1}{R_1}+s^2L_1C_1}$$

To obtain a fourth-order all-pole driving point impedance, the coefficients of s, $s^2$, $s^3$ in the numerator must be zero (i.e., poles). On expanding out the equation above we get,

$$Z_{2a}(s) + Z_{2b}(s)$$

$$= \frac{1 + s(R_1C_S + \frac{L_1}{R_1} - g_mL_1) + s^2(L_1C_S + L_1C_1 - L_1(C_S + C_1)) + s^3L_1C_SC_1R_1 - s^3L_1C_SC_1R_1}{g_m\left(1+\frac{s(C_S + C_1)}{g_m}+\frac{s^2C_1C_SR_1}{g_m}\right)\left(1+\frac{sL_1}{R_1}+s^2L_1C_1\right)}$$

We observe that the coefficients of $s^2$, $s^3$ in the numerator are equal to zero. The coefficient of s in the numerator can be made zero if L1, R1, gm and CS are chosen such that

$$\frac{R_1C_S}{g_m} = L_1\left(1 - \frac{1}{g_mR_1}\right)$$

The resulting effective series impedance $Z_{2a}(s) + Z_{2b}(s)$ is given by

$$Z_{2a}(s) + Z_{2b}(s) = \frac{1}{g_m\left(1+\frac{s(C_S + C_1)}{g_m}+\frac{s^2C_1C_SR_1}{g_m}\right)\left(1+\frac{sL_1}{R_1}+s^2L_1C_1\right)}$$

Having R2 and C2 in shunt with $Z_{2a}(s)+Z_{2b}(s)$ may still preserve the fourth-order all-pole nature of the effective driving point impedance $Z_4(s)$. The implementation of the negative LCR impedance, $Z_{2b}(s)$, is solved with a differential negative inductance -L that is implemented using a "negative" gyrator which is a gm-C gyrator with differential mode positive feedback. The negative RC impedance is implemented by coupling a resistor and capacitor in positive feedback around an amplifier of gain A with a negative output resistance.

Active synthesis of the negative RC could potentially contribute to distortion but a distortion cancellation mechanism involves a circuit to synthesize the negative RC impedance with appropriate biasing, which will contribute minimal distortion.

In many embodiments, $Z_{2a}(s)$ may comprise a transistor-based amplifier of gain $g_m$ coupled in parallel with a capacitance or capacitor C1. The source of the transistor couples with the input signal and couples with a feedback loop to the gate of the transistor via a resistance or resistor R1. The drain of the transistor couples with the impedance $Z_{2b}(s)$ and couples with a feedback loop to the gate of the transistor via a capacitance or capacitor Cs. Note that the impedance $Z_{2a}(s)$ may comprise this circuit or an equivalent circuit. The equivalent circuit may have the same transfer function as the transfer function for $Z_{2a}(s)$.

The impedance $Z_{2b}(s)$ illustrates an equivalent circuit to accomplish the transfer function described above. In this embodiment, the impedance $Z_{2b}(s)$ shunts $Z_{2a}(s)$ to a circuit ground and includes a negative inductance (-L1) coupled in parallel with a negative resistance (-R1) and coupled in parallel with a negative capacitance (-C1).

FIG. 1E illustrates an embodiment of a circuit to implement the negative inductance (-L1) 1040 of the impedance

$Z_{2b}(s)$ as a negative gyrator with differential mode positive feedback. The transfer function for the negative inductance (-L1) 1040 is

$$Zin = -2sL1 = 2C_L/gm1,2 \, gm3,4$$

where gm1,2 is the gain of transistor-based amplifier M1 and M2 and gm3,4 is the gain of transistor-based amplifier M3 and M4.

Gyrators may be used to synthesize active tunable inductors using transconductances and capacitors. A positive inductance is realized when there is a differential mode negative feedback in the loop, and a negative inductance may be realized using differential mode positive feedback in the loop. Note that in either case, there is common mode positive feedback. However, the loop gain of the common mode positive feedback is much lesser than unity due to the tail current source degeneration.

The impedance $Z_{2a}(s)$ couples in series with the negative inductance (-L1) 1040 at the top of the current mirror circuit 1041 formed by transistors 1042 and 1044 as well as at the top of the current mirror 1051 formed by the transistors 1052 and 1054. Thus, the voltages at the top of the current mirrors 1041 and 1051 are set by the voltage of the input signal applied to the load $Z_4(s)$ minus the voltage drop across the impedance $Z_{2a}(s)$ shown in FIG 1D.

The current mirror 1041 couples the drains of the transistors 1042 and 1044 such as p-channel metal oxide semiconductor (MOS) FETs (MOSFETs). The gates of the transistors 1042 and 1044 couple with the sources of the transistors M3 and M4 and couple with feedback loops through resistors 1046 and 1048 to the sources of the transistors 1042 and 1044. Note that the resistances 1046 and 1048 are ideally equivalent but are equivalent in view of manufacturing tolerances such as plus or minus 5%, 10%, 20%, and/or the like. The current mirror 1041 provides the same magnitude current to the sources of both the transistor M3 and the transistor M4 to produce the gain gm3,4.

The transistors M3 and M4 may comprise n-channel MOSFETs and may produce gains of gm3 and gm4, respectively. The sources of the transistors M3 and M4 couple with a source of first transistor $V_B$ to provide a bias current to the transistors M3 and M4. The gates of the transistors M3 and M4 couple with the output of the current mirror 1051 at the sources of transistors 1052 and 1054, respectively, and the sources of the transistors M1 and M2, respectively.

A first capacitance $C_L$ shunts the gate of transistor M3, the source of transistor 1052, and the source of transistor M1 to a circuit ground 1050. A second capacitance $C_L$ shunts the gate of transistor M4, the source of transistor 1054, and the source of transistor M2 to a circuit ground 1050 (or low voltage circuit rail).

The current mirror 1051 provides the same magnitude current to both the transistor M1 and transistor M2 to produce the gain gm1,2. The gates of the transistors 1052 and 1054 couple with the sources of transistors M1 and M2 via the resistances or resistors 1056 and 1058, respectively, and with the sources of transistors 1052 and 1054 via the resistances 1056 and 1058, respectively. Note that the resistances 1056 and 1058 are ideally equivalent but are equivalent in view of manufacturing tolerances such as plus or minus 5%, 10%, 20%, and/or the like.

The transistors M1 and M2 may comprise n-channel MOSFETs and may produce gains of gm1 and gm2, respectively. The source of transistor 1052 couples with the source of the transistor M1. The source of transistor 1054 couples with the source of transistor M2. The drains of transistors M1 and M2 couple with the source of a second transistor $V_B$. The second transistor $V_B$ shunts the drains of transistors M1 and M2 to the circuit ground 1050. Note that the first transistor $V_B$ sets a bias current for transistors M3 and M4 and the second transistor $V_B$ sets the bias current for transistors M1 and M2. The bias currents may reduce or cancel distortions from the transistors M1, M2, M3, and M4 for the negative gyrator of the negative inductance (-L1) 1040.

FIG. 1F illustrates an embodiment of a circuit 1070 to implement the parallel combination of the negative resistance (-R1) and the negative capacitance (-C1) of the impedance $Z_{2b}(s)$ by connecting a resistor and capacitor in positive feedback around an amplifier of gain A with a negative output resistance. The transfer function for the parallel combination of the negative resistance (-R1) and the negative capacitance (-C1) is

$$Zin = -2(R1 \parallel sC1)$$

The circuit 1070 couples with the output of the impedance $Z_{2a}(s)$ so the voltage is set by the voltage of the input signal at the load, $Z_4(S)$, minus the voltage drop across the impedance $Z_{2a}(s)$ shown in FIG 1D. Note that the amplifier used to synthesize the negative RC impedance has an n-channel MOSFET input transconductance with an n-channel MOSFET cross-coupled pair as the load. If amplifiers M12 and M34 are biased at different $gm/I_D$ such that $g(3)m_1,m_2 = g(3)m_3,m_4A^3$, then the net distortion current injected at the output of this amplifier of gain A is zero (wherein $I_D$ is the distortion current). Additionally, using a p-channel MOSFET cross-coupled pair also results in current reuse between the input transconductance and the cross-coupled pair, leading to power savings.

The impedance $Z_{2b}(s)$ from FIG. 1D couples with the drain of the transistor $V_{B1}$. $V_{B1}$ may couple with and set a bias current for the drains of the transistors M3 and M4. Transistors M3 and M4 may comprise p-channel MOSFETs having

a gain of $gm_3$ and $gm_4$, respectively. The source of transistor M3 may couple with the source of transistor M1 and the feedback loop coupled between the source of the transistor M1 and the gate of transistor M1. The feedback loop between the source of the transistor M1 and the gate of transistor M1 may comprise a first parallel combination of a resistance R1(A-1) and C1/(A-1). The gate of transistor M3 couples with the source of M2 and the feedback loop between the source of the transistor M2 and the gate of transistor M2.

The source of transistor M4 may couple with the source of transistor M2 and the feedback loop coupled between the source of the transistor M2 and the gate of transistor M2. The feedback loop between the source of the transistor M2 and the gate of transistor M2 may comprise a second parallel combination of a resistance R1(A-1) and a capacitance C1/(A-1). The gate of transistor M4 couples with the source of M1 and the feedback loop between the source of the transistor M1 and the gate of transistor M1.

The transistors M1 and M2 may comprise n-channel FETs such as n-channel MOSFETs. The sources of transistors M1 and M2 couple with a transistor $V_B$. The transistor $V_B$ may provide a second bias current for the sources of transistors M1 and M2 and shunt the sources of transistors M1 and M2 to the circuit ground 1072 (or low voltage circuit rail).

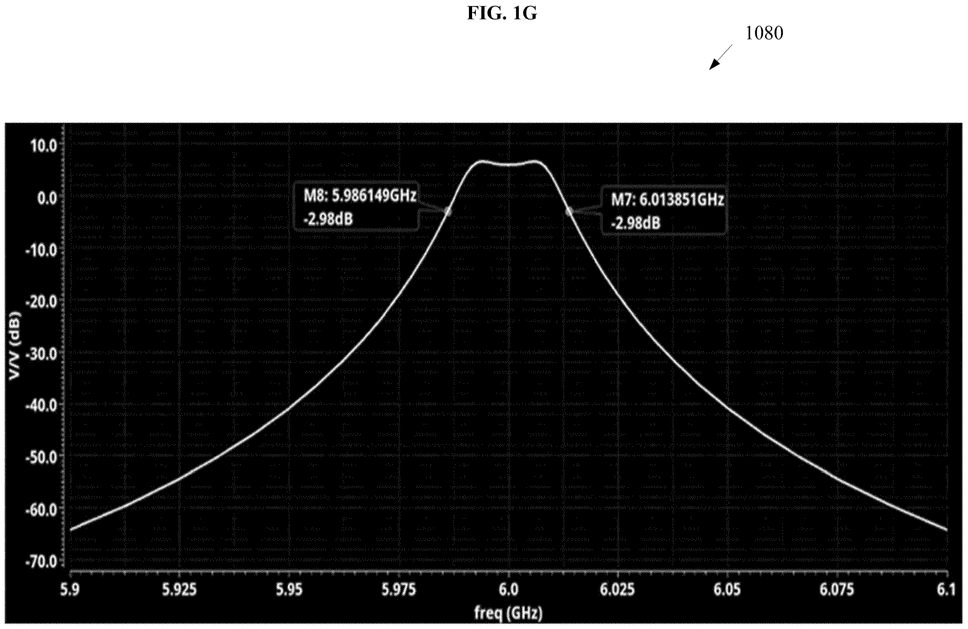

FIG. 1G illustrates an embodiment of a simulation 1080 for the fourth order driving point impedance with ideal components. The simulation includes an RF antenna input coupled with the N-path filter circuitry 1006 and the output of the N-path filter circuitry 1006 coupled with a baseband shunt-feedback amplifier. The input signal carrier frequency received via the antenna varied from 5.9-6.1 GHz. For the choice of component values, a bandwidth of 20 megahertz (MHz) was achieved with the 24dB/octave (80dB/decade) high frequency roll-off clearly visible.

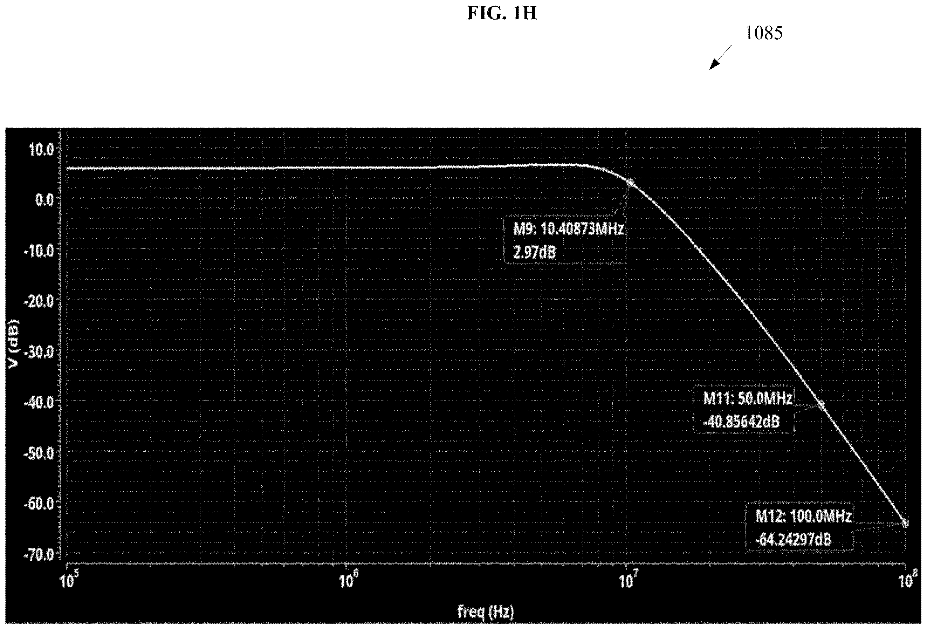

FIG. 1H illustrates an embodiment of a simulation 1085 of a baseband low-pass response of the bandpass transfer function from the simulation 1080 shown in FIG. 1G. The simulation 1085 shows the 24dB/octave (80dB/decade) roll-off.

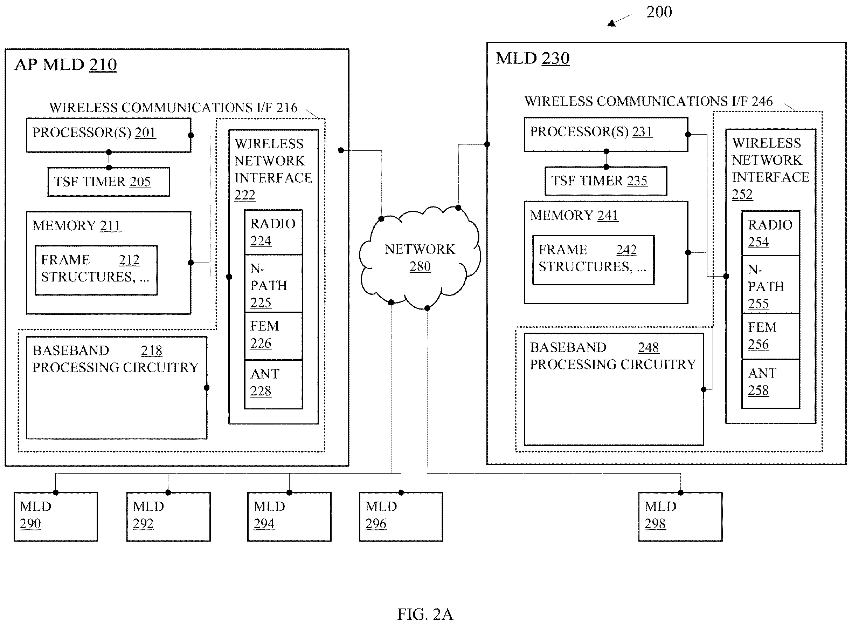

FIG. 2A depicts an embodiment of a system 200 including multiple multi-link devices (MLDs) to implement N-path filter circuitry 225 and 255 such as the N-path filter circuitry 1006 and, optionally, the baseband shunt-feedback amplifiers 1008 shown in FIGs 1A-1C. System 200 may transmit or receive as well as generate, decode, and interpret transmissions between an access point (AP) MLD 210 and multiple MLDs 230, 290, 292, 294, 296, and 298, associated with the AP MLD 210. The AP MLD 210 may be wired and/or wirelessly connected to each of the MLDs 230, 290, 292, 294, 296, and 298 via a network 280. Other embodiments may comprise stations (STAs) in lieu of the MLDs with the N-path filter circuitry 225 and 255, which may comprise single link devices that may or may not have dual band, triband, quad-band, and/or the like, capabilities. Note that an AP MLD or AP STA is a MLD or a STA that also includes some of or all the functionality of an AP. In some embodiments, the MLDs or STAs may be UEs and, in some embodiments, the UEs may also or alternatively incorporate the N-path filter circuitry 225 and 255 in receiver for cellular communications, Bluetooth® communications, and/or the like.

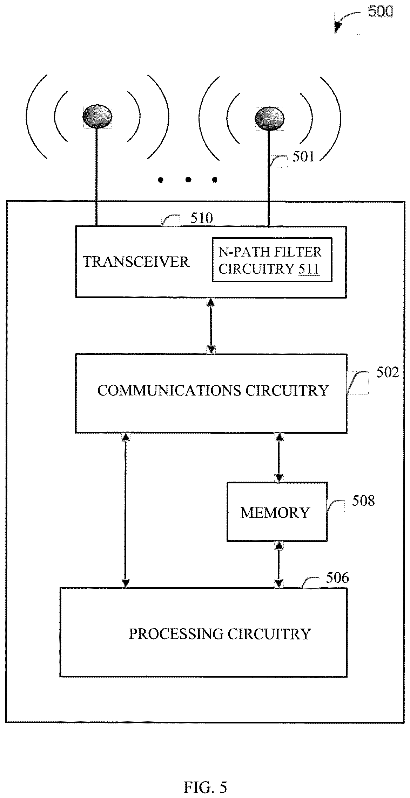

In some embodiments, the AP MLD 210 may be one of multiple AP MLDs affiliated with a collocated AP MLD (not shown) and MLD 230 may include one or more computer systems similar to that of the example machines/systems of FIGs 5, 6, 7, 8, and 11.

Each MLD 230, 290, 292, 294, 296, and 298, including the AP MLD 210 may include N-path filter circuitry, such as the N-path filter circuitry 255 of MLD 230 and the N-path filter circuitry 225 of AP MLD 210, to provide tunable RF filtering of up to 80dB/decade before the signal reaches the baseband amplifier. In some embodiments, the N-path filter circuitry 225 and/or 255 may reside at the load of an LNA in a front-end module 226 and 256 or in a radio 225 and 254. In other embodiments, the N-path filter circuitry 225 and/or 255 may couple with an antenna in a front-end module 226 and 256 or in a radio 225 and 254.

The AP MLD 210 and MLD 230 may comprise processor(s) 201 and memory 231, respectively. The processor(s) 201 may comprise any data processing device such as a microprocessor, a microcontroller, a state machine, and/or the like, and may execute instructions or code in the memory 211. The memory 211 may comprise a storage medium such as Dynamic Random Access Memory (DRAM), read only memory (ROM), buffers, registers, cache, flash memory, hard disk drives, solid-state drives, or the like. The memory 211 may store the frames, frame structures, frame headers, etc., 212 and may also comprise code for N-path filter circuitry such as code to create clock pulses with a LO or a synthesizer and code to generate, scramble, encode, decode, parse, and interpret MAC frames and/or PHY frames and physical layer protocol data units (PPDUs).

The baseband processing circuitry 218 may comprise a baseband processor and/or one or more circuits to implement an MLD station management entity (MM-SME) and a station management entity (SME) per link. The MM-SME may coordinate management of, communications between, and interactions between SMEs for the links.

In some embodiments, the SME may interact with a MAC layer management entity to perform MAC layer functionality and a PHY management entity to perform PHY functionality. In such embodiments, the baseband processing circuitry 218 may interact with processor(s) 201 to coordinate higher layer functionality with MAC layer and PHY functionality.

In some embodiments, the baseband processing circuitry 218 may interact with one or more analog devices to perform PHY functionality such as scrambling, encoding, modulating, and the like. In other embodiments, the baseband processing circuitry 218 may execute code to perform one or more of the PHY functionality such as scrambling, encoding, modulating, and the like.

The MAC layer functionality may execute MAC layer code stored in the memory 211. In further embodiments, the MAC layer functionality may interface the processor(s) 201.

The MAC layer functionality may communicate with the PHY via the SME to transmit a MAC frame such as an A-MPDU, in a PHY frame to the MLD 230. The MAC layer functionality may generate frames such as management, data, and control frames.

The PHY may prepare the MAC frame for transmission by, e.g., determining a preamble to prepend to a MAC frame to create a PHY frame. The preamble may include one or more short training field (STF) values, long training field (LTF) values, and signal (SIG) field values. A wireless network interface 222 or the baseband processing circuitry 218 may prepare the PHY frame as a scrambled, encoded, modulated PPDU in the time domain signals for the radio 224. Furthermore, the TSF timer 205 may provide a timestamp value for inclusion in a timestamp field of the PPDU to indicate the time at which the PPDU is transmitted.

After processing the PHY frame, a radio 225 may impress digital data onto subcarriers of RF frequencies for transmission and the FEM 226 may include a power amplifier to amplifier the subcarriers and carrier signal for transmission by electromagnetic radiation via elements of an antenna array or antennas 224 and via the network 280 to a receiving MLD STA of a MLD such as the MLD 230.

The wireless network I/F 222 also comprises a receiver. The receiver receives electromagnetic energy, extracts the digital data, and the analog PHY and/or the baseband processor 218 decodes a PHY frame and a MAC frame from a PPDU.

The MLD 230 may receive a PPDU such as an A-MPDU from the AP MLD 210 via the network 280. The MLD 230 may comprise processor(s) 231 and memory 241. The processor(s) 231 may comprise any data processing device such as a microprocessor, a microcontroller, a state machine, and/or the like, and may execute instructions or code in the memory 241. The memory 241 may comprise a storage medium such as Dynamic Random Access Memory (DRAM), read only memory (ROM), buffers, registers, cache, flash memory, hard disk drives, solid-state drives, or the like. The memory 241 may store 242 the frames, frame structures, frame headers, etc., and may also comprise code for N-path filter circuitry and code to generate, scramble, encode, decode, parse, and interpret MAC frames and/or PHY frames (PPDUs).

The baseband processing circuitry 248 may comprise a baseband processor and/or one or more circuits to implement a SME and the SME may interact with a MAC layer management entity to perform MAC layer functionality and a PHY management entity to perform PHY functionality. In such embodiments, the baseband processing circuitry 248 may interact with processor(s) 231 to coordinate higher layer functionality with MAC layer and PHY functionality.

In some embodiments, the baseband processing circuitry 218 may interact with one or more analog devices to perform PHY functionality such as descrambling, decoding, demodulating, and the like. In other embodiments, the baseband processing circuitry 218 may execute code to perform one or more of the PHY functionalities such as descrambling, decoding, demodulating, and the like.

The MLD 230 may receive the PPDU at the antennas 258, which pass the signals along to the FEM 256. The FEM 256 may amplify and filter the signals and pass the signals to the radio 254 (also referred to as RF circuitry or radio integrated circuit (IC) circuitry). The radio 254 may filter the carrier signals from the signals and determine if the signals represent a PPDU. If so, analog circuitry of the wireless network I/F 252 or physical layer functionality implemented in the baseband processing circuitry 248 may demodulate, decode, descramble, etc. the PPDU. The baseband processing circuitry 248 may identify, parse, and interpret a MAC service data unit (MSDU) from the physical layer service data unit (PSDU) of the PPDU.

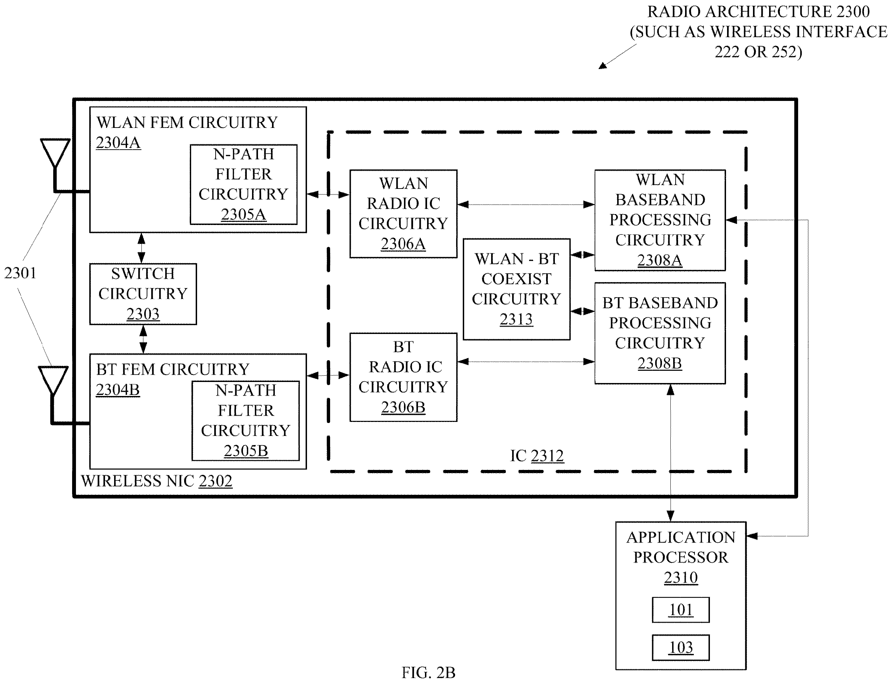

FIG. 2B is an embodiment of a block diagram of a radio architecture 2300 such as the wireless communications I/F 222 and 252 in accordance with some embodiments that may be implemented in, e.g., the AP MLD 210 and/or the MLD 230 of FIG. 1C. The radio architecture 2300 may include radio front-end module (FEM) circuitry 2304a-b, radio IC circuitry 2306a-b and baseband processing circuitry 2308a-b. The radio architecture 2300 as shown includes both Wireless Local Area Network (WLAN) functionality and Bluetooth (BT) functionality although embodiments are not so limited. In this disclosure, "WLAN" and "Wi-Fi" are interchangeable.

FEM circuitry 2304a-b may include a WLAN or Wi-Fi FEM circuitry 2304a and a Bluetooth (BT) FEM circuitry 2304b. The WLAN FEM circuitry 2304a may include a receive signal path comprising circuitry configured to operate on WLAN RF signals received from one or more antennas 2301, to amplify the received signals and to provide the amplified versions of the received signals to the WLAN radio IC circuitry 2306a for further processing. In many embodiments, the WLAN FEM circuitry 2304A may comprise N-path filter circuitry 2305A such as the N-path filter circuitry 1006 shown in FIGs. 1A-1C. The N-path filter circuitry 230 may provide up to 80dB/decade RF selectivity in the receive path and may comprise a fourth-order all-pole driving point impedance. In some embodiments, the input of the N-path filter circuitry 230 may couple with an antenna directly or via a duplexer. In some embodiments, the input of the N-path filter circuitry 2305A may couple with an output of an amplifier such as an LNA amplifier. In some embodiments, the output of the N-path filter circuitry 2305A may couple with baseband amplifiers such as baseband shunt-feedback amplifiers. Note that some embodiments may implement the N-path filter circuitry 2305A in the WLAN radio IC circuitry 2306A.

The BT FEM circuitry 2304b may include a receive signal path which may include circuitry configured to operate on BT RF signals received from one or more antennas 2301, to amplify the received signals and to provide the amplified versions of the received signals to the BT radio IC circuitry 2306b for further processing. In many embodiments, the BT FEM circuitry 2304B may comprise N-path filter circuitry 2305A such as the N-path filter circuitry 1006 shown in FIGs. 1A-1C. The N-path filter circuitry 230 may provide up to 80dB/decade RF selectivity in the receive path and may comprise a fourth-order all-pole driving point impedance. In some embodiments, the input of the N-path filter circuitry 230 may couple with an antenna directly or via a duplexer. In some embodiments, the input of the N-path filter circuitry 2305A may couple with an output of an amplifier such as an LNA amplifier. In some embodiments, the output of the N-path filter circuitry 230 may couple with baseband amplifiers such as baseband shunt-feedback amplifiers. Note that some embodiments may implement the N-path filter circuitry 2305B in the BT radio IC circuitry 2306B.

FEM circuitry 2304a may also include a transmit signal path which may include circuitry configured to amplify WLAN signals provided by the radio IC circuitry 2306a for wireless transmission by one or more of the antennas 2301. In addition, FEM circuitry 2304b may also include a transmit signal path which may include circuitry configured to amplify BT signals provided by the radio IC circuitry 2306b for wireless transmission by the one or more antennas. In the embodiment of FIG. 2B, although FEM 2304a and FEM 2304b are shown as being distinct from one another, embodiments are not so limited, and include within their scope the use of an FEM (not shown) that includes a transmit path and/or a receive path for both WLAN and BT signals, or the use of one or more FEM circuitries where at least some of the FEM circuitries share transmit and/or receive signal paths for both WLAN and BT signals.

Radio IC circuitry 2306a-b as shown may include WLAN radio IC circuitry 2306a and BT radio IC circuitry 2306b. The WLAN radio IC circuitry 2306a may include a receive signal path which may include circuitry to down-convert WLAN RF signals received from the FEM circuitry 2304a and provide baseband signals to WLAN baseband processing circuitry 2308a. BT radio IC circuitry 2306b may in turn include a receive signal path which may include circuitry to down-convert BT RF signals received from the FEM circuitry 2304b and provide baseband signals to BT baseband processing circuitry 2308b. WLAN radio IC circuitry 2306a may also include a transmit signal path which may include circuitry to up-convert WLAN baseband signals provided by the WLAN baseband processing circuitry 2308a and provide WLAN RF output signals to the FEM circuitry 2304a for subsequent wireless transmission by the one or more antennas 2301. BT radio IC circuitry 2306b may also include a transmit signal path which may include circuitry to up-convert BT baseband signals provided by the BT baseband processing circuitry 2308b and provide BT RF output signals to the FEM circuitry 2304b for subsequent wireless transmission by the one or more antennas 2301. In the embodiment of FIG. 1D, although radio IC circuitries 2306a and 2306b are shown as being distinct from one another, embodiments are not so limited, and include within their scope the use of a radio IC circuitry (not shown) that includes a transmit signal path and/or a receive signal path for both WLAN and BT signals, or the use of one or more radio IC circuitries where at least some of the radio IC circuitries share transmit and/or receive signal paths for both WLAN and BT signals.

Baseband processing circuity 2308a-b may include a WLAN baseband processing circuitry 2308a and a BT baseband processing circuitry 2308b. The WLAN baseband processing circuitry 2308a may include a memory, such as, for example, a set of RAM arrays in a Fast Fourier Transform or Inverse Fast Fourier Transform block (not shown) of the WLAN baseband processing circuitry 2308a. Each of the WLAN baseband circuitry 2308a and the BT baseband circuitry 2308b may further include one or more processors and control logic to process the signals received from the corresponding WLAN or BT receive signal path of the radio IC circuitry 2306a-b, and to also generate corresponding WLAN or BT baseband signals for the transmit signal path of the radio IC circuitry 2306a-b. Each of the baseband processing circuitries 2308a and 2308b may further include physical layer (PHY) and medium access control layer (MAC) circuitry, and may further interface with a device for generation and processing of the baseband signals and for controlling operations of the radio IC circuitry 2306a-b.

Referring still to FIG. 2B, according to the shown embodiment, WLAN-BT coexistence circuitry 2313 may include logic providing an interface between the WLAN baseband circuitry 2308a and the BT baseband circuitry 2308b to enable use cases requiring WLAN and BT coexistence. In addition, a switch circuitry 2303 may be provided between the WLAN FEM circuitry 2304a and the BT FEM circuitry 2304b to allow switching between the WLAN and BT radios according to application needs. In addition, although the antennas 2301 are connected to the WLAN FEM circuitry 2304a and the BT FEM circuitry 2304b, embodiments include within their scope the sharing of one or more antennas as between the WLAN and BT FEMs, or the provision of more than one antenna connected to each of FEM 2304a or 2304b.

In some embodiments, the front-end module circuitry 2304a-b, the radio IC circuitry 2306a-b, and baseband processing circuitry 2308a-b may be provided on a single radio card, such as wireless network interface card (NIC) 2302. In some other embodiments, the one or more antennas 2301, the FEM circuitry 2304a-b and the radio IC circuitry 2306a-b may be provided on a single radio card. In some other embodiments, the radio IC circuitry 2306a-b and the baseband processing circuitry 2308a-b may be provided on a single chip or integrated circuit (IC), such as IC 2312.

In some embodiments, the wireless NIC 2302 may include a WLAN radio card and may be configured for Wi-Fi communications, although the scope of the embodiments is not limited in this respect. In some of these embodiments, the radio architecture 2300 may be configured to receive and transmit orthogonal frequency division multiplexed (OFDM) or orthogonal frequency division multiple access (OFDMA) communication signals over a multicarrier communication channel. The OFDM or OFDMA signals may comprise a plurality of orthogonal subcarriers.

In some of these multicarrier embodiments, radio architecture 2300 may be part of a Wi-Fi communication station (STA) such as a wireless access point (AP), a base station or a mobile device including a Wi-Fi device. In some of these embodiments, radio architecture 2300 may be configured to transmit and receive signals in accordance with specific communication standards and/or protocols, such as any of the Institute of Electrical and Electronics Engineers (IEEE) standards including, 802.11n-2009, IEEE 802.11-2012, IEEE 802.11-2020, IEEE 802.11ay-2021, IEE 802.11ba-2021, IEEE 802.11ax-2021, and/or IEEE 802.11be standards and/or proposed specifications for WLANs, although the scope of embodiments is not limited in this respect. The radio architecture 2300 may also be suitable to transmit and/or receive communications in accordance with other techniques and standards.

In some embodiments, the radio architecture 2300 may be configured for high-efficiency Wi-Fi (HEW) communications in accordance with the IEEE 802.11ax-2021 standard. In these embodiments, the radio architecture 2300 may be configured to communicate in accordance with an OFDMA technique, although the scope of the embodiments is not limited in this respect.

In some other embodiments, the radio architecture 2300 may be configured to transmit and receive signals transmitted using one or more other modulation techniques such as spread spectrum modulation (e.g., direct sequence code division multiple access (DS-CDMA) and/or frequency hopping code division multiple access (FH-CDMA)), time-division multiplexing (TDM) modulation, and/or frequency-division multiplexing (FDM) modulation, although the scope of the embodiments is not limited in this respect.

In some embodiments, as further shown in FIG. 1D, the BT baseband circuitry 2308b may be compliant with a Bluetooth (BT) connectivity specification such as Bluetooth 5.0, or any other iteration of the Bluetooth specification.

In some embodiments, the radio architecture 2300 may include other radio cards, such as a cellular radio card configured for cellular (e.g., 3GPP such as LTE, LTE-Advanced, 4G, 5G, 6G, or subsequent generation communications).

In some IEEE 802.11 embodiments, the radio architecture 2300 may be configured for communication over various channel bandwidths including bandwidths having center frequencies of about 2.4 GHz, 5 GHz, and 6 GHz. The various bandwidths may include bandwidths of about 20 MHz, 40 MHz, 80 MHz, 160 MHz, 240 MHz, and 320 MHz with contiguous or non-contiguous bandwidths having increments of 20 MHz, 40 MHz, 80 MHz, 160 MHz, 240 MHz, and 320 MHz. The scope of the embodiments is not limited with respect to the above center frequencies, however.

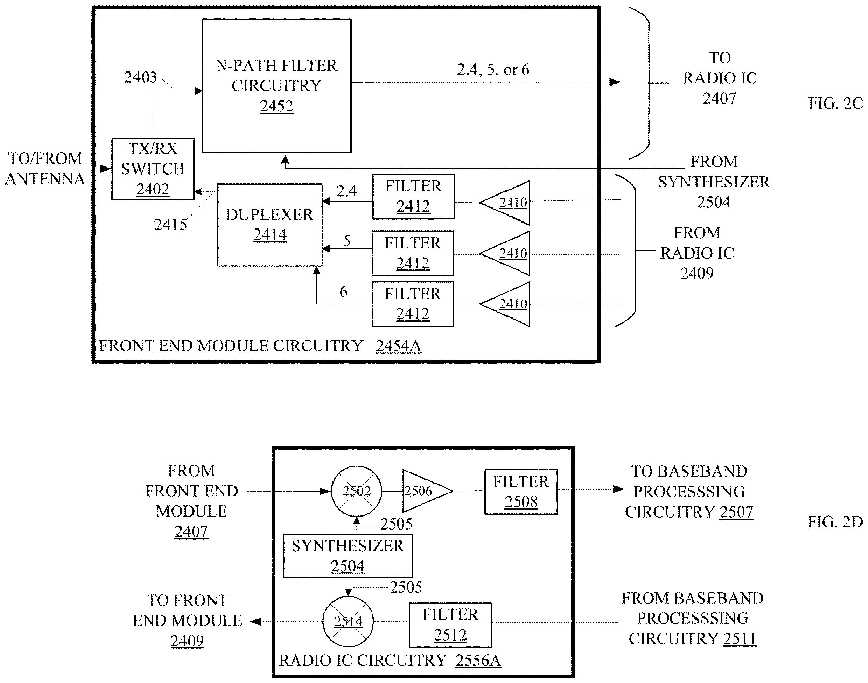

FIG. 2C illustrates an embodiment of FEM circuitry 2400 such as WLAN FEM circuitry 2304a shown in FIG. 2B in accordance with some embodiments. Although the example of FIG. 2C is described in conjunction with the WLAN FEM circuitry 2304a, the example of FIG. 2C may be described in conjunction with other configurations such as the BT FEM circuitry 2304b.

In some embodiments, the FEM circuitry 2400 may include a TX/RX switch 2402 to switch between transmit mode and receive mode operation. The FEM circuitry 2400 may include a receive signal path and a transmit signal path. The receive signal path of the FEM circuitry 2400 may include N-path filter circuitry 2452 to filter an output (e.g., to the radio IC circuitry 2306a-b (FIG. 2B)). The transmit signal path of the circuitry 2304a may include a power amplifier (PA) 2410 to amplify input RF signals (e.g., provided by the radio IC circuitry 2306a-b), and one or more filters 2412, such as band-pass filters (BPFs), low-pass filters (LPFs) or other types of filters, to generate RF signals 2415 for subsequent transmission (e.g., by one or more of the antennas 2301 (FIG. 2B)) via an example duplexer 2414.

In some dual-mode embodiments for Wi-Fi communication, the FEM circuitry 2404A may be configured to operate in the 2.4 GHz frequency spectrum, the 5 GHz frequency spectrum, or the 6 GHz frequency spectrum. In these embodiments, the receive signal path of the FEM circuitry 2400 may include the N-path filter circuitry 2452, which is controllable for each spectrum via the clock signals from the synthesizer 2504 (or a LO) as shown. In these embodiments, the transmit signal path of the FEM circuitry 2400 may also include a power amplifier 2410 and a filter 2412, such as a BPF, an LPF or another type of filter for each frequency spectrum and a transmit signal path duplexer 2414 to provide the signals of one of the different spectrums onto a single transmit path for subsequent transmission by the one or more of the antennas 2301 (FIG. 2B). In some embodiments, BT communications may utilize the 2.4 GHz signal paths and may utilize the same FEM circuitry 2400 as the one used for WLAN communications.

FIG. 2D illustrates an embodiment of radio IC circuitry 2506a in accordance with some embodiments. The radio IC circuitry 2306a is one example of circuitry that may be suitable for use as the WLAN or BT radio IC circuitry 2306a/2306b (FIG. 2B), although other circuitry configurations may also be suitable. Alternatively, the example of FIG. 2D may be described in conjunction with the example BT radio IC circuitry 2306b.

In some embodiments, the radio IC circuitry 2306a may include a receive signal path and a transmit signal path. The receive signal path of the radio IC circuitry 2306a may include at least mixer circuitry 2502, such as, for example, down-conversion mixer circuitry, amplifier circuitry 2506 (such as the baseband sunt-feed-back amplifiers 1008 in FIG. 1A-1C) and filter circuitry 2508. The transmit signal path of the radio IC circuitry 2306a may include at least filter circuitry 2512 and mixer circuitry 2514, such as, for example, up-conversion mixer circuitry. Radio IC circuitry 2306a may also include synthesizer circuitry 2504 for synthesizing a frequency 2505 for use by the mixer circuitry 2502 and the mixer circuitry 2514. The mixer circuitry 2502 and/or 2514 may each, according to some embodiments, be configured to provide direct conversion functionality. The latter type of circuitry presents a much simpler architecture as compared with standard super-heterodyne mixer circuitries, and any flicker noise brought about by the same may be alleviated for example through the use of OFDM modulation. FIG. 2D illustrates only a simplified version of a radio IC circuitry, and may include, although not shown, embodiments where each of the depicted circuitries may include more than one component. For instance, mixer circuitry 2514 may each include one or more mixers, and filter circuitries 2508 and/or 2512 may each include one or more filters, such as one or more BPFs and/or LPFs according to application needs. For example, when mixer circuitries are of the direct-conversion type, they may each include two or more mixers.

In some embodiments, mixer circuitry 2502 may be configured to down-convert RF signals 2407 received from the FEM circuitry 2304a-b (FIG. 2B) based on the synthesized frequency 2505 provided by synthesizer circuitry 2504. The amplifier circuitry 2506 may be configured to amplify the down-converted signals and the filter circuitry 2508 may include an LPF configured to remove unwanted signals from the down-converted signals to generate output baseband signals 2507. Output baseband signals 2507 may be provided to the baseband processing circuitry 2308a-b (FIG. 2B) for further processing. In some embodiments, the output baseband signals 2507 may be zero-frequency baseband signals, although this is not a requirement. In some embodiments, mixer circuitry 2502 may comprise passive mixers, although the scope of the embodiments is not limited in this respect.

In some embodiments, the mixer circuitry 2514 may be configured to up-convert input baseband signals 2511 based on the synthesized frequency 2505 provided by the synthesizer circuitry 2504 to generate RF output signals 2409 for the FEM circuitry 2304a-b. The baseband signals 2511 may be provided by the baseband processing circuitry 2308a-b and may be filtered by filter circuitry 2512. The filter circuitry 2512 may include an LPF or a BPF, although the scope of the embodiments is not limited in this respect.

In some embodiments, the mixer circuitry 2502 and the mixer circuitry 2514 may each include two or more mixers and may be arranged for quadrature down-conversion and/or up-conversion respectively with the help of synthesizer 2504. In some embodiments, the mixer circuitry 2502 and the mixer circuitry 2514 may each include two or more mixers each configured for image rejection (e.g., Hartley image rejection). In some embodiments, the mixer circuitry 2502 and the mixer circuitry 2514 may be arranged for direct down-conversion and/or direct up-conversion, respectively. In some embodiments, the mixer circuitry 2502 and the mixer circuitry 2514 may be configured for super-heterodyne operation, although this is not a requirement.

Mixer circuitry 2502 may comprise, according to one embodiment: quadrature passive mixers (e.g., for the in-phase (I) and quadrature phase (Q) paths). In such an embodiment, RF input signal 2407 from FIG. 2D may be downconverted to provide I and Q baseband output signals to be sent to the baseband processor. The N-path filter circuitry 2452 may output I and Q baseband output signals and may be driven by clock pulses having, e.g., a 25% duty cycle from a LO frequency (fLO) from a local oscillator or a synthesizer, such as LO frequency 2505 of synthesizer 2504 (FIG. 2D).

Quadrature passive mixers may be driven by zero and ninety-degree time-varying LO switching signals provided by a quadrature circuitry which may be configured to receive a LO frequency (fLO) from a local oscillator or a synthesizer, such as LO frequency 2505 of synthesizer 2504 (FIG. 2D). In some embodiments, the LO frequency may be the carrier frequency, while in other embodiments, the LO frequency may be a fraction of the carrier frequency (e.g., one-half the carrier frequency, one-third the carrier frequency). In some embodiments, the zero and ninety-degree time-varying switching signals may be generated by the synthesizer, although the scope of the embodiments is not limited in this respect.

In some embodiments, the LO signals may differ in duty cycle (the percentage of one period in which the LO signal is high) and/or offset (the difference between start points of the period). In some embodiments, the LO signals may have an 85% duty cycle and an 80% offset. In some embodiments, each branch of the mixer circuitry (e.g., the in-phase (I) and quadrature phase (Q) path) may operate at an 80% duty cycle, which may result in a significant reduction is power consumption.

The RF input signal 2407 (FIG. 2C) may comprise a balanced signal, although the scope of the embodiments is not limited in this respect. The I and Q baseband output signals may be provided to low-noise amplifier, such as amplifier circuitry 2506 (FIG. 2D) or to filter circuitry 2508 (FIG. 2D).

In some embodiments, the output baseband signals 2507 and the input baseband signals 2511 may be analog baseband signals, although the scope of the embodiments is not limited in this respect. In some alternate embodiments, the output baseband signals 2507 and the input baseband signals 2511 may be digital baseband signals. In these alternate embodiments, the radio IC circuitry may include analog-to-digital converter (ADC) and digital-to-analog converter (DAC) circuitry.

In some dual-mode embodiments, a separate radio IC circuitry may be provided for processing signals for each spectrum, or for other spectrums not mentioned here, although the scope of the embodiments is not limited in this respect.

In some embodiments, the synthesizer circuitry 2504 may be a fractional-N synthesizer or a fractional N/N+1 synthesizer, although the scope of the embodiments is not limited in this respect as other types of frequency synthesizers may be suitable. For example, synthesizer circuitry 2504 may be a delta-sigma synthesizer, a frequency multiplier, or a synthesizer comprising a phase-locked loop with a frequency divider. According to some embodiments, the synthesizer circuitry 2504 may include digital synthesizer circuitry. An advantage of using a digital synthesizer circuitry is that, although it may still include some analog components, its footprint may be scaled down much more than the footprint of an analog synthesizer circuitry. In some embodiments, frequency input into synthesizer circuit 2504 may be provided by a voltage-controlled oscillator (VCO), although that is not a requirement. A divider control input may further be provided by either of the baseband processing circuitry 2308a-b (FIG. 2B) depending on the desired output frequency 2505. In some embodiments, a divider control input (e.g., N) may be determined from a look-up table (e.g., within a Wi-Fi card) based on a channel number and a channel center frequency as determined or indicated by the example application processor 2310. The application processor 2310 may include, or otherwise be connected to, one of the example secure signal converter 101 or the example received signal converter 103 (e.g., depending on which device the example radio architecture is implemented in).

In some embodiments, synthesizer circuitry 2504 may be configured to generate a carrier frequency as the output frequency 2505, while in other embodiments, the output frequency 2505 may be a fraction of the carrier frequency (e.g., one-half the carrier frequency, one-third the carrier frequency). In some embodiments, the output frequency 2505 may be a LO frequency (fLO).

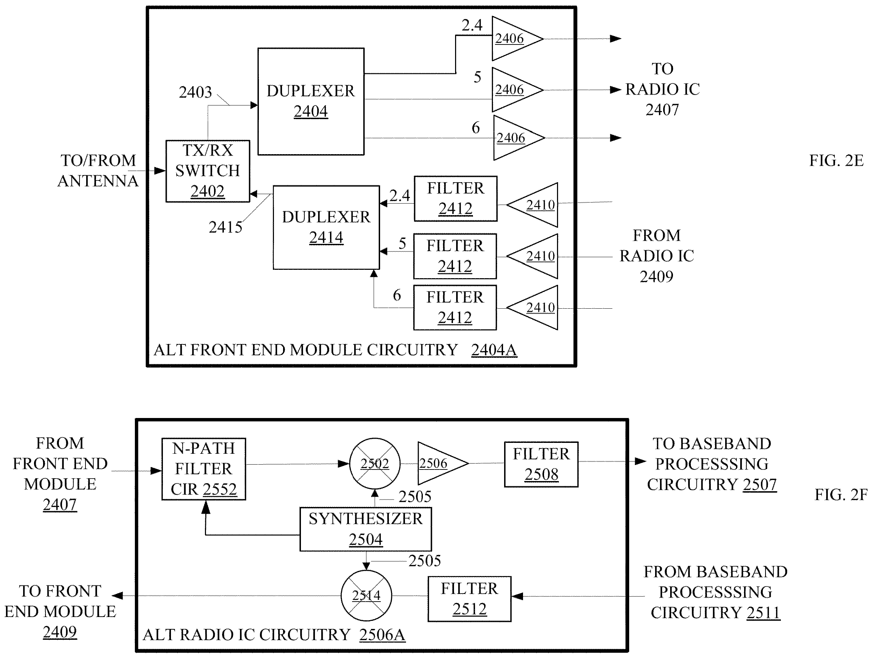

FIGS. 2E and 2F may offer alternative embodiments of FEM circuitry 2404A and radio IC circuitry 2506A that may include the N-path filter circuitry 2522 in the radio IC circuitry 2506A rather than in the FEM circuitry 2404A. In FIG. 2E, the FEM circuitry 2404A may comprise an LNA 2406 for all carrier frequency paths (e.g., 2.4 GHz 5GHz, and 6 GHz) or, in alternative embodiments, one LNA 2406 per carrier frequency after the duplexer 2404. In FIG. 2F, the radio IC circuitry 2506A may comprise N-path filter circuitry 2552 coupled with the synthesizer 2504 to generate baseband output signals such as I and Q output signals.

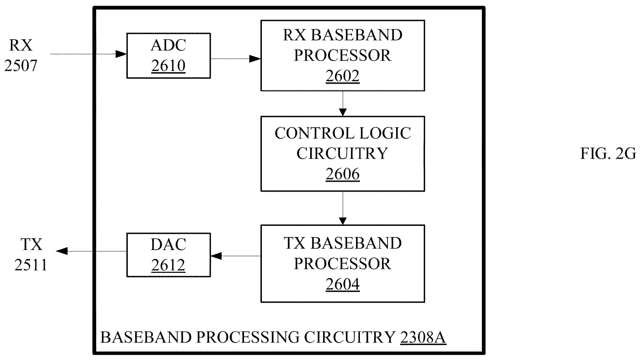

FIG. 2G illustrates an embodiment of a functional block diagram of baseband processing circuitry 2308a in accordance with some embodiments. The baseband processing circuitry 2308a is one example of circuitry that may be suitable for use as the baseband processing circuitry 2308a (FIG. 2B), although other circuitry configurations may also be suitable. Alternatively, the example of FIG. 2G may be used to implement the example BT baseband processing circuitry 2308b of FIG. 2B.

The baseband processing circuitry 2308a may include a receive baseband processor (RX BBP) 2602 for processing receive baseband signals 2509 provided by the radio IC circuitry 2306a-b (FIG. 2B), by the radio IC circuitry 2556a (FIG. 2D), or by the radio IC circuitry 2506a (FIG. 2F), and a transmit baseband processor (TX BBP) 2604 for generating transmit baseband signals 2511 for the radio IC circuitry 2306a-b. The baseband processing circuitry 2308a may also include control logic 2606 for coordinating the operations of the baseband processing circuitry 2308a.

In some embodiments (e.g., when analog baseband signals are exchanged between the baseband processing circuitry 2308a-b and the radio IC circuitry 2306a-b), the baseband processing circuitry 2308a may include ADC 2610 to convert analog baseband signals 2609 received from the radio IC circuitry 2306a-b to digital baseband signals for processing by the RX BBP 2602. In these embodiments, the baseband processing circuitry 2308a may also include DAC 2612 to convert digital baseband signals from the TX BBP 2604 to analog baseband signals 2611.

In some embodiments that communicate OFDM signals or OFDMA signals, such as through baseband processor 2308a, the transmit baseband processor 2604 may be configured to generate OFDM or OFDMA signals as appropriate for transmission by performing an inverse fast Fourier transform (IFFT). The receive baseband processor 2602 may be configured to process received OFDM signals or OFDMA signals by performing an FFT. In some embodiments, the receive baseband processor 2602 may be configured to detect the presence of an OFDM signal or OFDMA signal by performing an autocorrelation, to detect a preamble, such as a short preamble, and by performing a cross-correlation, to detect a long preamble. The preambles may be part of a predetermined frame structure for Wi-Fi communication.

Referring back to FIG. 2B, in some embodiments, the antennas 2301 (FIG. 2B) may each comprise one or more directional or omnidirectional antennas, including, for example, dipole antennas, monopole antennas, patch antennas, loop antennas, microstrip antennas or other types of antennas suitable for transmission of RF signals. In some multiple-input multiple-output (MIMO) embodiments, the antennas may be effectively separated to take advantage of spatial diversity and the different channel characteristics that may result. Antennas 2301 may each include a set of phased-array antennas, although embodiments are not so limited.

Although the radio architecture 2300 is illustrated as having several separate functional elements, one or more of the functional elements may be combined and may be implemented by combinations of software-configured elements, such as processing elements including digital signal processors (DSPs), and/or other hardware elements. For example, some elements may comprise one or more microprocessors, DSPs, field-programmable gate arrays (FPGAs), application specific integrated circuits (ASICs), radio-frequency integrated circuits (RFICs) and combinations of various hardware and logic circuitry for performing at least the functions described herein. In some embodiments, the functional elements may refer to one or more processes operating on one or more processing elements.

Some embodiments may be used in conjunction with one or more types of wireless communication signals and/or systems following one or more wireless communication protocols, for example, radio frequency (RF), infrared (IR), frequency-division multiplexing (FDM), orthogonal FDM (OFDM), time-division multiplexing (TDM), time-division multiple access (TDMA), extended TDMA (E-TDMA), general packet radio service (GPRS), extended GPRS, code-division multiple access (CDMA), wideband CDMA (WCDMA), CDMA 2000, single-carrier CDMA, multi-carrier CDMA, multi-carrier modulation (MDM), discrete multi-tone (DMT), Bluetooth®, global positioning system (GPS), Wi-Fi, Wi-Max, ZigBee, ultra-wideband (UWB), global system for mobile communications (GSM), 2G, 2.5G, 3G, 3.5G, 4G, fifth generation (5G) mobile networks, 6th generation mobile networks, 3GPP, long term evolution (LTE), LTE advanced, enhanced data rates for GSM Evolution (EDGE), or the like. Other embodiments may be used in various other devices, systems, and/or networks.

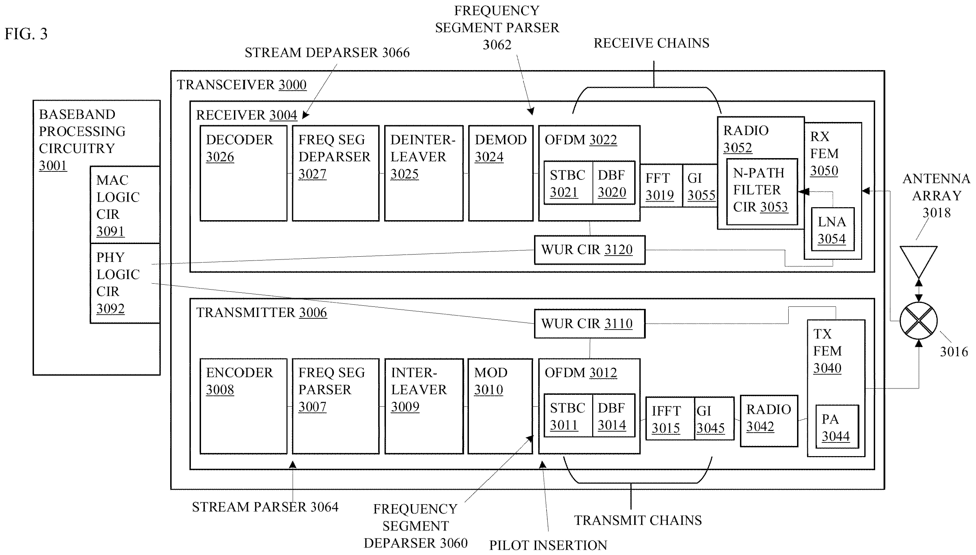

FIG. 3 depicts an embodiment of an apparatus to generate, transmit, receive, and interpret or decode physical layer (PHY) frames and medium access control (MAC) layer frames. The apparatus comprises a transceiver 3000 coupled with baseband processing circuitry 3001. The baseband processing circuitry 3001 may comprise a MAC logic circuitry 3091 and PHY logic circuitry 3092. In other embodiments, the baseband processing circuitry 3001 may be included on the transceiver 3000.

The MAC logic circuitry 3091 and PHY logic circuitry 3092 may comprise code executing on processing circuitry of a baseband processing circuitry 3001; circuitry to implement operations of functionality of the MAC or PHY; or a combination of both.

The MAC logic circuitry 3091 may determine a frame such as a MAC management frame and the PHY logic circuitry 3092 may determine the physical layer protocol data unit (PPDU) by prepending the frame, also called a MAC protocol data unit (MPDU), with a physical layer (PHY) preamble for transmission of the MAC management frame via the antenna array 3018. The PHY logic circuitry 3092 may cause transmission of the MAC management frame in the PPDU.

The transceiver 3000 comprises a receiver 3004 and a transmitter 3006. Embodiments have many different combinations of modules to process data because the configurations are deployment specific. FIG. 3 illustrates some of the modules that are common to many embodiments. In some embodiments, one or more of the modules may be implemented in circuitry separate from the baseband processing circuitry 3001. In some embodiments, the baseband processing circuitry 3001 may execute code in processing circuitry of the baseband processing circuitry 3001 to implement one or more of the modules.

In the present embodiment, the transceiver 3000 also includes WUR circuitry 3110 and 3120. The WUR circuitry 3110 may comprise circuitry to use portions of the transmitter 3006 (a transmitter of the wireless communications I/F such as wireless communications I/Fs 1216 and 1246 of FIG. 1C) to generate a WUR packet. For instance, the WUR circuitry 3110 may generate, e.g., an OOK signal with OFDM symbols to generate a WUR packet for transmission via the antenna array 3018. In other embodiments, the WUR may comprise an independent circuitry that does not use portions of the transmitter 3006.

Note that a MLD such as the AP MLD 1210 in FIG. 1C may comprise multiple transmitters to facilitate concurrent transmissions on multiple contiguous and/or non-contiguous carrier frequencies.

The transmitter 3006 may comprise one or more of or all the modules including an encoder 3008, a stream deparser 3066, a frequency segment parser 3007, an interleaver 3009, a modulator 3010, a frequency segment deparser 3060, an OFDM 3012, an Inverse Fast Fourier Transform (IFFT) module 3015, a GI module 3045, and a transmitter front end 3040. The encoder 3008 of transmitter 3006 receives and encodes a data stream destined for transmission from the MAC logic circuitry 3091 with, e.g., a binary convolutional coding (BCC), a low-density parity check coding (LDPC), and/or the like. After coding, scrambling, puncturing and post-FEC (forward error correction) padding, a stream parser 3064 may optionally divide the data bit streams at the output of the FEC encoder into groups of bits. The frequency segment parser 3007 may receive data stream from encoder 3008 or streams from the stream parser 3064 and optionally parse each data stream into two or more frequency segments to build a contiguous or non-contiguous bandwidth based upon smaller bandwidth frequency segments. The interleaver 3009 may interleave rows and columns of bits to prevent long sequences of adjacent noisy bits from entering a BCC decoder of a receiver.

The modulator 3010 may receive the data stream from interleaver 3009 and may impress the received data blocks onto a sinusoid of a selected frequency for each stream via, e.g., mapping the data blocks into a corresponding set of discrete amplitudes of the sinusoid, or a set of discrete phases of the sinusoid, or a set of discrete frequency shifts relative to the frequency of the sinusoid. In some embodiments, the output of modulator 3010 may optionally be fed into the frequency segment deparser 3060 to combine frequency segments in a single, contiguous frequency bandwidth of, e.g., 320 MHz. Other embodiments may continue to process the frequency segments as separate data streams for, e.g., a non-contiguous 160+160 MHz bandwidth transmission.

After the modulator 3010, the data stream(s) are fed to an OFDM 3012. The OFDM 3012 may comprise a space-time block coding (STBC) module 3011, and a digital beamforming (DBF) module 3014. The STBC module 3011 may receive constellation points from the modulator 3010 corresponding to one or more spatial streams and may spread the spatial streams to a greater number of space-time streams. Further embodiments may omit the STBC.

The OFDM 3012 impresses or maps the modulated data formed as OFDM symbols onto a plurality of orthogonal subcarriers, so the OFDM symbols are encoded with the subcarriers or tones. The OFDM symbols may be fed to the DBF module 3014. Generally, digital beam forming uses digital signal processing algorithms that operate on the signals received by, and transmitted from, an array of antenna elements. Transmit beamforming processes the channel state to compute a steering matrix that is applied to the transmitted signal to optimize reception at one or more receivers. This is achieved by combining elements in a phased antenna array in such a way that signals at particular angles experience constructive interference while others experience destructive interference.

The IFFT module 3015 may perform an inverse discrete Fourier transform (IDFT) on the OFDM symbols to map on the subcarriers. The guard interval (GI) module 3045 may insert guard intervals by prepending to the symbol a circular extension of itself. The GI module 3045 may also comprise windowing to optionally smooth the edges of each symbol to increase spectral decay.

The output of the GI module 3045 may enter the radio 3042 to convert the time domain signals into radio signals by combining the time domain signals with subcarrier frequencies to output into the transmitter front end module (TX FEM) 3040. The transmitter front end 3040 may comprise a with a power amplifier (PA) 3044 to amplify the signal and prepare the signal for transmission via the antenna array 3018. In many embodiments, entrance into a spatial reuse mode by a communications device such as a STA may reduce the amplification by the PA 3044 to reduce channel interference caused by transmissions.

The transceiver 3000 may also comprise duplexers 3016 connected to antenna array 3018. The antenna array 3018 radiates the information bearing signals into a time-varying, spatial distribution of electromagnetic energy that can be received by an antenna of a receiver. In several embodiments, the receiver 3004 and the transmitter 3006 may each comprise its own antenna(s) or antenna array(s).

The transceiver 3000 may comprise a receiver 3004 for receiving, demodulating, and decoding information bearing communication signals. The receiver 3004 may comprise a receiver front-end module (RX FEM) 3050 to detect the signal, detect the start of the packet, and amplify the subcarriers via a low noise amplifier (LNA) 3054 to output to the radio 3052.

In the present embodiment, the radio 3052 may comprise a N-path filter circuitry 3053 having an input coupled with the LNA 3054 and an output coupled with two baseband amplifiers. The N-path filter circuitry 3053 may have four N-path filters, one to capture energy from the input signal responsive to a 0 degree clock pulse, one to capture energy from the input signal responsive to a 90 degree clock pulse, one to capture energy from the input signal responsive to a 180 degree clock pulse, and one to capture energy from the input signal responsive to a 270 degree clock pulse. A local clock synthesizer or LO may generate the clock pulses with, e.g., a 25 percent duty cycle at a frequency of the incoming signal.

The N-path filter circuitry 3052 may comprise an output shunted to a circuit ground by fourth order driving point impedances to capture the energy from the N-path filters such as the N-path circuitry shown in FIGs. 1A and 1C. The baseband amplifiers may couple with the output of the N-path filter circuitry 3053 to output I and Q analog radio signals based on the input signal receive by the N-path filter circuitry 3053 from the LNA.

The radio 3052 may convert the radio signals into time domain signals to output to the GI module 3055 by removing the subcarrier frequencies from each tone of the radio signals.

The receiver 3004 may comprise a GI module 3055 and a fast Fourier transform (FFT) module 3019. The GI module 3055 may remove the guard intervals and the windowing and the FFT module 3019 may transform the communication signals from the time domain to the frequency domain.

The receiver 3004 may also comprise an OFDM 3022, a frequency segment parser 3062, a demodulator 3024, a deinterleaver 3025, a frequency segment deparser 3027, a stream deparser 3066, and a decoder 3026. An equalizer may output the weighted data signals for the OFDM packet to the OFDM 3022. The OFDM 3022 extracts signal information as OFDM symbols from the plurality of subcarriers onto which information-bearing communication signals are modulated.

The OFDM 3022 may comprise a DBF module 3020, and an STBC module 3021. The received signals are fed from the equalizer to the DBF module 3020. The DBF module 3020 may comprise algorithms to process the received signals as a directional transmission directed toward to the receiver 3004. And the STBC module 3021 may transform the data streams from the space-time streams to spatial streams.

The output of the STBC module 3021 may enter a frequency segment parser 3062 if the communication signal is received as a single, contiguous bandwidth signal to parse the signal into, e.g., two or more frequency segments for demodulation and deinterleaving.

The demodulator 3024 demodulates the spatial streams. Demodulation is the process of extracting data from the spatial streams to produce demodulated spatial streams. The deinterleaver 3025 may deinterleave the sequence of bits of information. The frequency segment deparser 3027 may optionally deparse frequency segments as received if received as separate frequency segment signals or may deparse the frequency segments determined by the optional frequency segment parser 3062. The decoder 3026 decodes the data from the demodulator 3024 and transmits the decoded information, the MPDU, to the MAC logic circuitry 3091.

The MAC logic circuitry 3091 may parse the MPDU based upon a format defined in the communications device for a frame to determine the particular type of frame by determining the type value and the subtype value. The MAC logic circuitry 3091 may then interpret the remainder of MPDU.

While the description of FIG. 3 focuses primarily on a single spatial stream system for simplicity, many embodiments are capable of multiple spatial stream transmissions and use parallel data processing paths for multiple spatial streams from the PHY logic circuitry 3092 through to transmission. Further embodiments may include the use of multiple encoders to afford implementation flexibility.

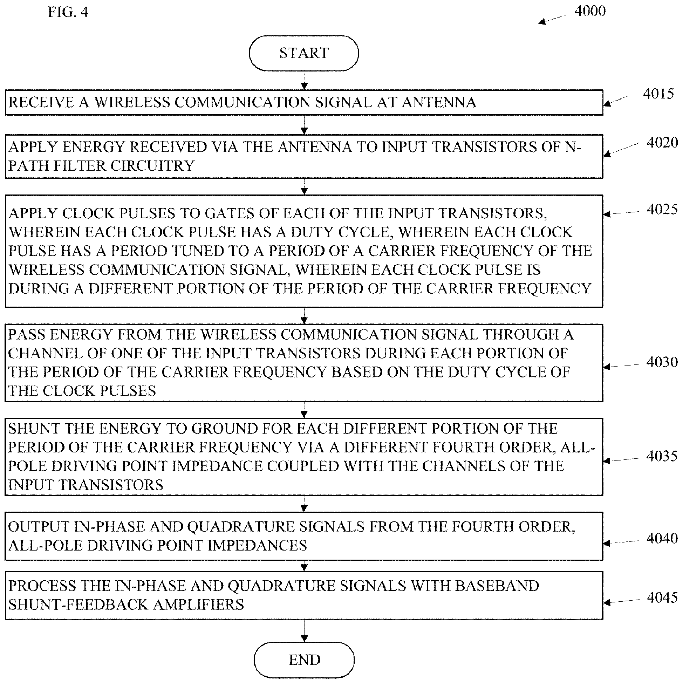

FIG. 4 depicts an embodiment of a flowchart of a process 4000 to implement N-path filter circuitry such as the N-path filter circuitry discussed in FIGs. 1-3. At element 4015, a receiver for wireless communications such as Bluetooth® communications, WiFi communications, cellular communications, or the like may receive a wireless communication signal at an antenna. At 4020, the receiver circuitry may apply the energy received via the antenna to input transistors of N-path filter circuitry. In some embodiments, the antenna may pass the energy to a duplexer and a LNA prior to passing the energy to an input of N-path filter circuitry. In some embodiments, the antenna may pass the energy to a duplexer prior to passing the energy to an input of N-path filter circuitry. In some embodiments, the antenna may pass the energy to a LNA prior to passing the energy to an input of N-path filter circuitry.

At 4025, clock circuitry such as a LO, a synthesizer circuit, or a LO of a synthesizer circuit may apply clock pulses to gates of each of the input transistors of the N-path filter circuitry. In many embodiments, each clock pulse has a duty cycle and has a period tuned to a period of a carrier frequency of the wireless communication signal. Each of the input transistors may receive a different clock pulse at the gate of the transistor and each clock pulse may be during a different portion of the period of the carrier frequency such that channels of the input transistors may pass and distribute energy from portions of the period of the carrier frequency of the wireless communication signal to loads coupled with the input transistors. In such embodiments, the distribution of the energy may be based on the duty cycle of the clock pulses (element 4030). In many embodiments, all the energy of the wireless communication signal is distributed to the loads coupled with the input transistors of the N-path filter circuitry.

At 4030, the loads coupled with the channels of the input transistors of the N-path filter circuitry may shunt the different portions of the energy of the wireless communication signal to a circuit ground or a low voltage circuit rail via different fourth order, all-pole driving point impedances coupled with the channels of the input transistors. For instance, the number of input transistors may comprise four and each input transistor may pass energy to a different load during a different clock pulse. In such embodiments, the clock pulses may have a 25 percent duty cycle and each clock pulse may occur during a different portion of the period of the carrier frequency of the incoming wireless communication signal. The four-input transistor may pass a different one-fourth of the energy of the incoming wireless communication signal to each of four different fourth order, all-pole driving point impedances, which shunt the energy to the circuit ground.

At 4040, the loads of input transistors may output energy in the form of an in-phase (I) signal and a quadrature (Q) signal to subsequent circuitry of the receiver. At 4045, the subsequent circuitry of the receiver may apply the in-phase signal and a quadrature signal to I and Q baseband shunt-feedback amplifiers to reduce distortion and increase linearity of the I and Q baseband signals for processing.

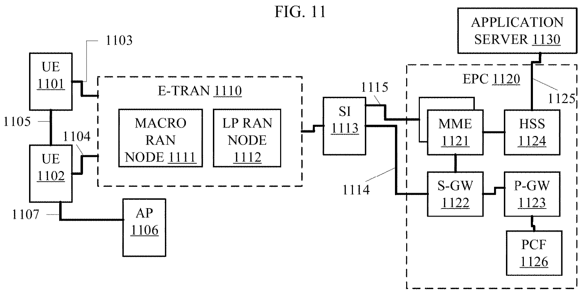

FIG. 5 shows a functional diagram of an exemplary communication station 500, in accordance with one or more example embodiments of the present disclosure. In one embodiment, FIG. 5 illustrates a functional block diagram of a communication station that may be suitable for use as an AP MLD 210 (FIG. 2A), a MLD 230 (FIG. 2A), an AP 1106 (FIG. 11), a UE 1101 (FIG. 11), or a Bluetooth® device in accordance with some embodiments. The communication station 500 may also be suitable for use as other wireless device(s) 1020 such as a handheld device, a mobile device, a cellular telephone, a smartphone, a tablet, a netbook, a wireless terminal, a laptop computer, a wearable computer device, a femtocell, a high data rate (HDR) subscriber station, an access point, an access terminal, or other personal communication system (PCS) device.

The communication station 500 may include communications circuitry 502 and a transceiver 510 for transmitting and receiving signals to and from other communication stations using one or more antennas 501. The transceiver 510 may comprise N-path filter circuitry 511 coupled with a baseband amplifier such as the N-path filter circuitry 1006 and baseband sunt-feedback amplifier 1008 shown in FIGs. 1A and 1C. In many embodiments, the N-path filter circuitry may comprise a fourth order N-path filter using an N-path filter loaded by an active fourth order all-pole driving point impedance that has a filtering profile of up to 80dB/decade. In some embodiments, an input of the N-path filter circuitry 511 may couple with the antenna 501 or an LNA and the output of the baseband amplifier may comprise analog I and Q input signals for I and Q mixers or for an ADC to convert the I and Q signals to digital signals for processing by a baseband processor of the communications circuitry 502.

The communications circuitry 502 may include circuitry that can operate the physical layer (PHY) communications and/or medium access control (MAC) communications for controlling access to the wireless medium, and/or any other communications layers for transmitting and receiving signals. The communication station 500 may also include processing circuitry 506 and memory 508 arranged to perform the operations described herein. In some embodiments, the communications circuitry 502 and the processing circuitry 506 may be configured to perform operations detailed in the above figures, diagrams, and flows.

In accordance with some embodiments, the communications circuitry 502 may be arranged to contend for a wireless medium and configure frames or packets for communicating over the wireless medium. The communications circuitry 502 may be arranged to transmit and receive signals. The communications circuitry 502 may also include circuitry for modulation/demodulation, upconversion/downconversion, filtering, amplification, etc. In some embodiments, the processing circuitry 506 of the communication station 500 may include one or more processors. In other embodiments, two or more antennas 501 may be coupled to the communications circuitry 502 arranged for sending and receiving signals. The memory 508 may store information for configuring the processing circuitry 506 to perform operations for configuring and transmitting MAC and PHY message frames and performing the various operations described herein. The memory 508 may include any type of memory, including non-transitory memory, for storing information in a form readable by a machine (e.g., a computer). For example, the memory 508 may include a computer-readable storage device, read-only memory (ROM), random-access memory (RAM), magnetic disk storage media, optical storage media, flash-memory devices and other storage devices and media.

In some embodiments, the communication station 500 may be part of a portable wireless communication device, such as a personal digital assistant (PDA), a laptop or portable computer with wireless communication capability, a web tablet, a wireless telephone, a smartphone, a wireless headset, a pager, an instant messaging device, a digital camera, an access point, a television, a medical device (e.g., a heart rate monitor, a blood pressure monitor, etc.), a wearable computer device, or another device that may receive and/or transmit information wirelessly.

In some embodiments, the communication station 500 may include one or more antennas 501. The antennas 501 may include one or more directional or omnidirectional antennas, including, for example, dipole antennas, monopole antennas, patch antennas, loop antennas, microstrip antennas, or other types of antennas suitable for transmission of RF signals. In some embodiments, instead of two or more antennas, a single antenna with multiple apertures may be used. In these embodiments, each aperture may be considered a separate antenna. In some multiple-input multiple-output (MIMO) embodiments, the antennas may be effectively separated for spatial diversity and the different channel characteristics that may result between each of the antennas and the antennas of a transmitting station.

In some embodiments, the communication station 500 may include one or more of a keyboard, a display, a non-volatile memory port, multiple antennas, a graphics processor, an application processor, speakers, and other mobile device elements. The display may be an LCD screen including a touch screen.

Although the communication station 500 is illustrated as having several separate functional elements, two or more of the functional elements may be combined and may be implemented by combinations of software-configured elements, such as processing elements including digital signal processors (DSPs), and/or other hardware elements. For example, some elements may include one or more microprocessors, DSPs, field- programmable gate arrays (FPGAs), application specific integrated circuits (ASICs), radio- frequency integrated circuits (RFICs) and combinations of various hardware and logic circuitry for performing at least the functions described herein. In some embodiments, the functional elements of the communication station 500 may refer to one or more processes operating on one or more processing elements.

Certain embodiments may be implemented in one or a combination of hardware, firmware, and software. Other embodiments may also be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media. In some embodiments, the communication station 500 may include one or more processors and may be configured with instructions stored on a computer-readable storage device.

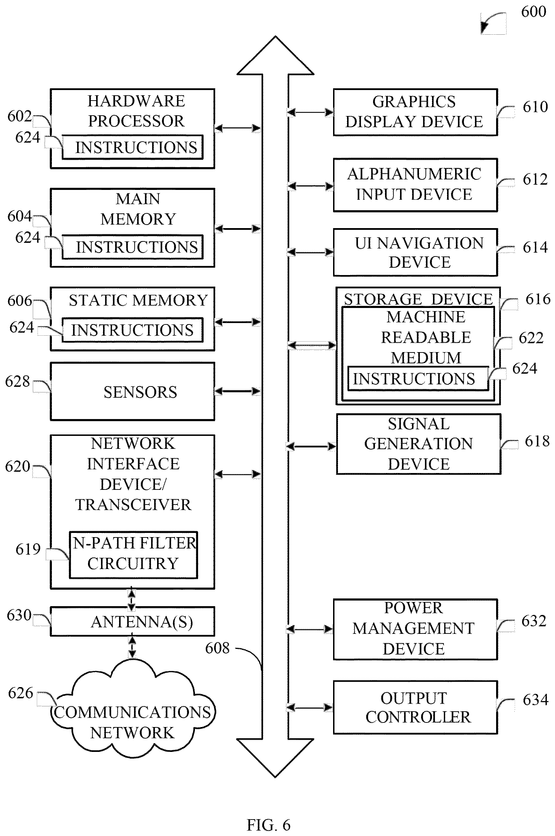

FIG. 6 illustrates a block diagram of an example of a machine 600 or system upon which any one or more of the techniques (e.g., methodologies) discussed herein may be performed. For instance, the machine may comprise any STAs, UEs, computing devices, and/or the like discussed in conjunction with FIGs. 1-5. In some embodiments, the machine 600 may operate as a standalone device or may be connected (e.g., networked) to other machines. In a networked deployment, the machine 600 may operate in the capacity of a server machine, a client machine, or both in server-client network environments. In an example, the machine 600 may act as a non-AP STA or an AP STA in WiFi network environments, a UE in cellular network environments, or a Bluetooth® device in Bluetooth® environment. The machine 600 may be a personal computer (PC), a tablet PC, a set-top box (STB), a personal digital assistant (PDA), a mobile telephone, a wearable computer device, a web appliance, a network router, a switch or bridge, or any machine capable of executing instructions (sequential or otherwise) that specify actions to be taken by that machine, such as link management. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), or other computer cluster configurations.

Examples, as described herein, may include or may operate on logic or a number of components, modules, or mechanisms. Modules are tangible entities (e.g., hardware) capable of performing specified operations when operating. A module includes hardware. In an example, the hardware may be specifically configured to carry out a specific operation (e.g., hardwired). In another example, the hardware may include configurable execution units (e.g., transistors, circuits, etc.) and a computer-readable medium containing instructions where the instructions configure the execution units to carry out a specific operation when in operation. The configuring may occur under the direction of the execution units or a loading mechanism. Accordingly, the execution units are communicatively coupled to the computer-readable medium when the device is operating. In this example, the execution units may be a member of more than one module. For example, under operation, the execution units may be configured by a first set of instructions to implement a first module at one point in time and reconfigured by a second set of instructions to implement a second module at a second point in time.

The machine (e.g., computer system) 600 may include a hardware processor 602 (e.g., a central processing unit (CPU), a graphics processing unit (GPU), a hardware processor core, or any combination thereof), a main memory 604 and a static memory 606, some of or all which may communicate with each other via one or more interlinks (e.g., buses or high-speed interconnects) 608. Note that the single set of interlinks 608 may be representative of the physical interlinks in some embodiments but is not representative of the physical interlinks 608 in other embodiments. For example, the main memory 604 may couple directly with the hardware processor 602 via high-speed interconnects or a main memory bus. The high-speed interconnects typically connect two devices, and the bus is generally designed to interconnect two or more devices and include an arbitration scheme to provide fair access to the bus by the two or more devices. A main bus may, for example, interconnect one or more processors such as the hardware processor 602 with a main memory such as the main memory 604 and with a hub or controller (not shown). The hub or controller may interconnect the main bus with other devices shown such as a graphics display device 610, sensors 628, a power management device 632, and/or the like.

The machine 600 may further include the power management device 632, the graphics display device 610, an alphanumeric input device 612 (e.g., a keyboard), and a user interface (UI) navigation device 614 (e.g., a mouse). In an example, the graphics display device 610, alphanumeric input device 612, and UI navigation device 614 may be a touch screen display. The machine 600 may additionally include a storage device (i.e., drive unit) 616, a signal generation device 618 (e.g., a speaker), a N-path filter circuitry 619 of a network interface device/transceiver 620 coupled to antenna(s) 630, and one or more sensors 628, such as a global positioning system (GPS) sensor, a compass, an accelerometer, or other sensor. The machine 600 may include an output controller 634, such as a serial (e.g., universal serial bus (USB), parallel, or other wired or wireless (e.g., infrared (IR), near field communication (NFC), etc.) connection to communicate with or control one or more peripheral devices (e.g., a printer, a card reader, etc.)).

The operations in accordance with one or more example embodiments of the present disclosure may be carried out by a baseband processor such as the baseband processing circuitry 218 and/or 248 shown in FIG. 2A. The baseband processor may be configured to generate corresponding baseband signals. The baseband processor may further include physical layer (PHY) and medium access control (MAC) layer circuitry and may further interface with the hardware processor 602 for generation and processing of the baseband signals and for controlling operations of the main memory 604 and the storage device 616. The baseband processor may be provided on a single radio card, a single chip, or an integrated circuit (IC).

The storage device 616 may include a machine readable medium 622 on which is stored one or more sets of data structures or instructions 624 (e.g., software) embodying or utilized by any one or more of the techniques or functions described herein. The instructions 624 may also reside, completely or at least partially, within the main memory 604, within the static memory 606, within the baseband processor, or within the hardware processor 602 during execution thereof by the machine 600. In an example, one or any combination of the hardware processor 602, the baseband processor, the main memory 604, the static memory 606, or the storage device 616 may constitute machine-readable media.

The N-path filter circuitry 619 may reside in in cellular communications circuitry, Bluetooth® communications circuitry, and/or WiFi communications circuitry to implement communications such as full-duplex communications. The N-path filter circuitry 619 may comprise a fourth order N-path filter using an N-path filter loaded by an active fourth order all-pole driving point impedance. In some embodiments, the synthesized fourth order N-path filter is at the output of a low noise amplifier (LNA). In some embodiments, the synthesized fourth order N-path filter is at a passive mixer-first receiver. In many embodiments, the location of the N-path filter circuitry may vary based on system sensitivity specifications. The down-converted baseband output of the N-path filter circuitry which has a filtering profile of 80dB/decade is then amplified by baseband shunt-feedback amplifiers and the outputs of the baseband shunt-feedback amplifiers may comprise I and Q analog input signals. A/D converters may convert the I and Q analog input signals for use by a baseband processor of the Network interface device/ transceiver 620.

While the machine-readable medium 622 is illustrated as a single medium, the term "machine-readable medium" may include a single medium or multiple media (e.g., a centralized or distributed database, a centralized or distributed memory, and/or associated caches, registers, buffers, and servers) configured to store the one or more instructions 624.

Various embodiments may be implemented fully or partially in software and/or firmware. This software and/or firmware may take the form of instructions or code contained in or on a non-transitory computer-readable storage medium.

Those instructions may then be read and executed by one or more processors to enable performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read only memory (ROM); random access memory (RAM); magnetic disk storage media; optical storage media; a flash memory, etc.

The term "machine-readable medium" may include any medium that is capable of storing, encoding, or carrying instructions for execution by the machine 600 and that cause the machine 600 to perform any one or more of the functions discussed in the present disclosure, or that is capable of storing, encoding, or carrying data structures used by or associated with such instructions. Non-limiting machine-readable medium examples may include solid-state memories and optical and magnetic media. In an example, a massed machine-readable medium includes a machine-readable medium with a plurality of particles having resting mass. Specific examples of massed machine-readable media may include non-volatile memory, such as semiconductor memory devices (e.g., electrically programmable read-only memory (EPROM), or electrically erasable programmable read-only memory (EEPROM)) and flash memory devices; magnetic disks, such as internal hard disks and removable disks; magneto-optical disks; and CD-ROM and DVD- ROM disks.

The instructions 624 may further be transmitted or received over a communications network 626 using a transmission medium via the network interface device/transceiver 620 utilizing any one of a number of transfer protocols (e.g., frame relay, internet protocol (IP), transmission control protocol (TCP), user datagram protocol (UDP), hypertext transfer protocol (HTTP), etc.). Example communications networks may include a local area network (LAN), a wide area network (WAN), a packet data network (e.g., the Internet), mobile telephone networks (e.g., cellular networks), plain old telephone (POTS) networks, wireless data networks (e.g., Institute of Electrical and Electronics Engineers (IEEE) 802.11 family of standards known as Wi-Fi®, IEEE 802.16 family of standards known as WiMax®), IEEE 802.15.4 family of standards, and peer-to-peer (P2P) networks, among others. In an example, the network interface device/transceiver 620 may include one or more physical jacks (e.g., Ethernet, coaxial, or phone jacks) or one or more antennas to connect to the communications network 626. In an example, the network interface device/transceiver 620 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding, or carrying instructions for execution by the machine 600 and includes digital or analog communications signals or other intangible media to facilitate communication of such software.

The operations and processes described and shown above may be carried out or performed in any suitable order as desired in various implementations. Additionally, in certain implementations, at least a portion of the operations may be carried out in parallel. Furthermore, in certain implementations, less than or more than the operations described may be performed.

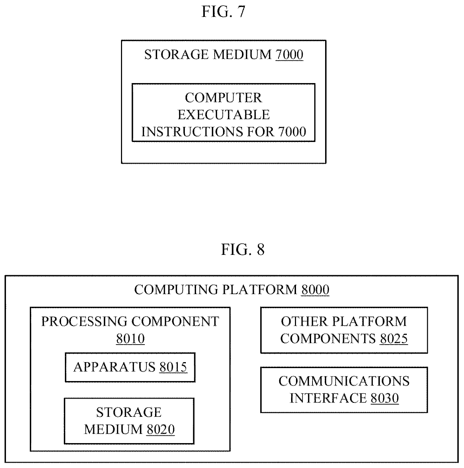

FIG. 7 illustrates an example of a storage medium 7000 to store code and data such as logic to implement clock pulses for the N-path filter circuitry 1006 shown in FIGs. 1A, 1B, and 1C and/or the other logic discussed herein. Storage medium 7000 may comprise an article of manufacture. In some examples, storage medium 7000 may include any non-transitory computer readable medium or machine-readable medium, such as an optical, magnetic or semiconductor storage. Storage medium 7000 may store diverse types of computer executable instructions, such as instructions to implement logic flows and/or techniques described herein. Examples of a computer readable or machine-readable storage medium may include any tangible media capable of storing electronic data, including volatile memory or non-volatile memory, removable or non-removable memory, erasable or non-erasable memory, writeable or re-writeable memory, and so forth. Examples of computer executable instructions may include any suitable type of code, such as source code, compiled code, interpreted code, executable code, static code, dynamic code, object-oriented code, visual code, and the like.

FIG. 8 illustrates an example computing platform 8000 such as the STAs illustrated in FIGs. 1A-G. In some examples, as shown in FIG. 8, computing platform 8000 may include a processing component 8010, other platform components, and a communications interface 8030 to implement N-path filter circuitry coupled with baseband processors and an LNA or a mixer in a mixer first receiver as shown and/or discussed in conjunction with FIGs. 1A-1C. According to some examples, computing platform 8000 may be a computing device such as a server in a system such as a data center or server farm that supports a manager or controller for managing configurable computing resources as mentioned above. In some embodiments, the computing platform may comprise a mobile device such as a smart phone, a tablet, a notebook, a laptop, a headset, a power amplifier, a television, a speaker, a video/audio streaming device, a stereo, and/or the like.

According to some examples, processing component 8010 may execute processing operations or logic for apparatus 8015 described herein. Processing component 8010 may include various hardware elements, software elements, or a combination of both. Examples of hardware elements may include devices, logic devices, components, processors, microprocessors, circuits, circuitry, processor circuits, processing circuitry, circuit elements (e.g., transistors, resistors, capacitors, inductors, and so forth), integrated circuits (ICs), application specific integrated circuits (ASIC), programmable logic devices (PLD), digital signal processors (DSP), field programmable gate array (FPGA), memory units, logic gates, registers, semiconductor device, chips, microchips, chip sets, and so forth. Examples of software elements, which may reside in the storage medium 8020, may include software components, programs, applications, computer programs, application programs, device drivers, system programs, software development programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. While discussions herein describe elements of embodiments as software elements and/or hardware elements, decisions to implement an embodiment using hardware elements and/or software elements may vary in accordance with any number of design considerations or factors, such as desired computational rate, power levels, heat tolerances, processing cycle budget, input data rates, output data rates, memory resources, data bus speeds and other design or performance constraints.

In some examples, other platform components 8025 may include common computing elements, such as one or more processors, multi-core processors, co-processors, memory units, chipsets, controllers, peripherals, interfaces, oscillators, timing devices, video cards, audio cards, accelerator cards, neural network accelerator cards, multimedia input/output (I/O) components (e.g., digital displays), power supplies, and so forth. Examples of memory units may include without limitation various types of computer readable and machine readable storage media in the form of one or more higher speed memory units, such as read-only memory (ROM), random-access memory (RAM), dynamic RAM (DRAM), Double-Data-Rate DRAM (DDRAM), synchronous DRAM (SDRAM), static RAM (SRAM), programmable ROM (PROM), erasable programmable ROM (EPROM), electrically erasable programmable ROM (EEPROM), flash memory, polymer memory such as ferroelectric polymer memory, ovonic memory, phase change or ferroelectric memory, silicon-oxide-nitride-oxide-silicon (SONOS) memory, magnetic or optical cards, an array of devices such as Redundant Array of Independent Disks (RAID) drives, solid state memory devices (e.g., universal serial bus (USB) memory), solid state drives (SSD) and any other type of storage media suitable for storing information.

In some examples, communications interface 8030 may include logic and/or features to support a communication interface. For these examples, communications interface 8030 may include one or more communication interfaces that operate according to various communication protocols or standards to communicate over direct or network communication links. Direct communications may occur via use of communication protocols or standards described in one or more industry standards (including progenies and variants) such as those associated with the Peripheral Component Interconnect (PCI) Express specification. Network communications may occur via use of communication protocols or standards such as those described in one or more Ethernet standards promulgated by the Institute of Electrical and Electronics Engineers (IEEE). For example, one such Ethernet standard may include IEEE 802.3-2012, Carrier sense Multiple access with Collision Detection (CSMA/CD) Access Method and Physical Layer Specifications, Published in December 2012 (hereinafter "IEEE 802.3"). Network communication may also occur according to one or more OpenFlow specifications such as the OpenFlow Hardware Abstraction API Specification. Network communications may also occur according to Infiniband Architecture Specification, Volume 1, Release 1.3, published in March 2015 ("the Infiniband Architecture specification").

Computing platform 8000 may be part of a computing device that may be, for example, a server, a server array or server farm, a web server, a network server, an Internet server, a workstation, a mini-computer, a main frame computer, a supercomputer, a network appliance, a web appliance, a distributed computing system, multiprocessor systems, processor-based systems, or combination thereof. Accordingly, various embodiments of the computing platform 8000 may include or exclude functions and/or specific configurations of the computing platform 8000 described herein.

The components and features of computing platform 8000 may comprise any combination of discrete circuitry, ASICs, logic gates and/or single chip architectures. Further, the features of computing platform 8000 may comprise microcontrollers, programmable logic arrays and/or microprocessors or any combination of the foregoing where suitably appropriate. Note that hardware, firmware and/or software elements may be collectively or individually referred to herein as "logic". "Logic circuitry" may comprise one or more or any combination of hardware elements, software elements, code, data, processing components 8010, other platform components 8025, communications interface 8030, and/or the like, configured to perform any of the functionality discussed with respect to FIGs. 1-8.

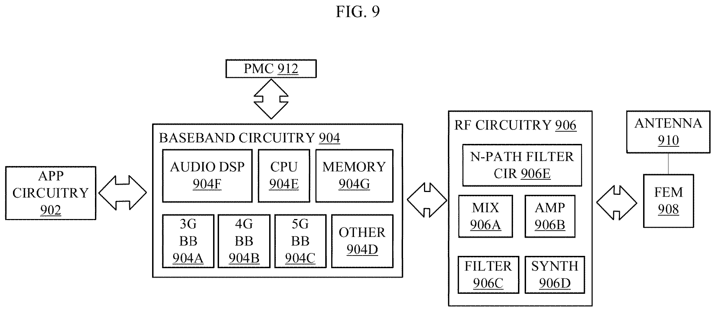

FIG. 9 illustrates example components of a device 900 in accordance with some embodiments such as the base stations and UEs shown in FIG. 11. In some embodiments, the device 900 may include application circuitry 902, baseband circuitry 904, Radio Frequency (RF) circuitry 906, front-end module (FEM) circuitry 908, one or more antennas 910, and power management circuitry (PMC) 912 coupled together at least as shown. The components of the illustrated device 900 may be included in a UE or a RAN node such as a base station or gNB. In some embodiments, the device 900 may include less elements (e.g., a RAN node may not utilize application circuitry 902, and instead include a processor/controller to process IP data received from an Evolved Packet Core (EPC) network). In some embodiments, the device 900 may include additional elements such as, for example, memory/storage, display, camera, sensor, or input/output (I/O) interface. In other embodiments, the components described below may be included in more than one device (e.g., said circuitries may be separately included in more than one device for Cloud-RAN (C-RAN) implementations).

The application circuitry 902 may include one or more application processors. For example, the application circuitry 902 may include circuitry such as, but not limited to, one or more single-core or multi-core processors. The processor(s) may include any combination of general-purpose processors and dedicated processors (e.g., graphics processors, application processors, etc.). The processors may be coupled with or may include memory/storage and may be configured to execute instructions stored in the memory/storage to enable various applications or operating systems to run on the device 900. In some embodiments, processors of application circuitry 902 may process IP data packets received from an EPC.

The baseband circuitry 904 may include circuitry such as, but not limited to, one or more single-core or multi-core processors. The baseband circuitry 904 may include one or more baseband processors or control logic to process baseband signals received from a receive signal path of the RF circuitry 906 and to generate baseband signals for a transmit signal path of the RF circuitry 906. The baseband circuity 904 may interface with the application circuitry 902 for generation and processing of the baseband signals and for controlling operations of the RF circuitry 906. For example, in some embodiments, the baseband circuitry 904 may include a third generation (3G) baseband processor 904A, a fourth generation (4G) baseband processor 904B, a fifth generation (5G) baseband processor 904C, or other baseband processor(s) 904D for other existing generations, generations in development or to be developed in the future (e.g., second generation (2G), sixth generation (6G), etc.). In many embodiments, the fourth generation (4G) baseband processor 904B may include capabilities for generation and processing of the baseband signals for LTE radios and the fifth generation (5G) baseband processor 904C may capabilities for generation and processing of the baseband signals for new radios (NRs).

The baseband circuitry 904 (e.g., one or more of baseband processors 904A-D) may handle various radio control functions that enable communication with one or more radio networks via the RF circuitry 906. In other embodiments, some of or all the functionality of baseband processors 904A-D may be included in modules stored in the memory 904G and executed via a Central Processing Unit (CPU) 904E. The radio control functions may include, but are not limited to, signal modulation/demodulation, encoding/decoding, radio frequency shifting, etc.

In some embodiments, modulation/demodulation circuitry of the baseband circuitry 904 may include Fast-Fourier Transform (FFT), precoding, or constellation mapping/demapping functionality. In some embodiments, encoding/decoding circuitry of the baseband circuitry 904 may include convolution, tail-biting convolution, turbo, Viterbi, or Low-Density Parity Check (LDPC) encoder/decoder functionality. Embodiments of modulation/demodulation and encoder/-decoder functionality are not limited to these examples and may include other suitable functionality in other embodiments.

In some embodiments, the baseband circuitry 904 may include one or more audio digital signal processor(s) (DSP) 904F. The audio DSP(s) 904F may be include elements for compression/decompression and echo cancellation and may include other suitable processing elements in other embodiments. Components of the baseband circuitry may be suitably combined in a single chip, a single chipset, or disposed on a same circuit board in some embodiments. In some embodiments, some of or all the constituent components of the baseband circuitry 904 and the application circuitry 902 may be implemented together such as, for example, on a system on a chip (SOC). In some embodiments, the baseband circuitry 904 may provide for communication compatible with one or more radio technologies. For example, in some embodiments, the baseband circuitry 904 may support communication with an evolved universal terrestrial radio access network (E-UTRAN) or other wireless metropolitan area networks (WMAN), a wireless local area network (WLAN), a wireless personal area network (WPAN). Embodiments in which the baseband circuitry 904 is configured to support radio communications of more than one wireless protocol may be referred to as multi-mode baseband circuitry.

The RF circuitry 906 may enable communication with wireless networks using modulated electromagnetic radiation through a non-solid medium. In various embodiments, the RF circuitry 906 may include switches, filters, amplifiers, etc. to facilitate the communication with the wireless network. In some embodiments, the RF circuitry 906 may implement N-path filter circuitry 906E such as the N-path filter circuitry 1006 in FIGs 1A and 1C and may also implement baseband shunt-feedback amplifiers coupled with the output of the N-path filter circuitry 906E such as the baseband shunt-feedback amplifiers 1008 in FIGs 1A and 1C. In some embodiments, the input of the N-path filter circuitry 906E may couple with the antenna 910, the N-path filter circuitry 906E may couple with the input/output of the baseband shunt-feedback amplifiers of amplifier circuitry 906B. In other embodiments, the input of the N-path filter circuitry 906E may couple with a LNA of amplifier circuitry 906B, the N-path filter circuitry 906E may couple with the input/output of the baseband shunt-feedback amplifiers of amplifier circuitry 906B.

The output of the baseband shunt-feedback amplifiers of amplifier circuitry 906B may couple with ADCs in the RF circuitry 906 or in the baseband circuitry 904. In some embodiments, the output of the baseband shunt-feedback amplifiers of amplifier circuitry 906B may couple with I and Q mixers of mixer circuitry 906A and the output of the I and Q mixers of mixer circuitry 906A may couple with the ADC in the RF circuitry 906 or in the baseband circuitry 904. In many embodiments, a LO of synthesizer circuitry 906D may couple with the gates of transistors at the input of the N-path filter circuitry 906E to provide one or more clock pulses to open and close channels of the transistors at the input of the N-path filter circuitry 906E such as shown in FIGs. 1A, 1B, and 1C.

In some embodiments, the RF circuitry 906 may include a receive signal path which may include circuitry to down-convert RF signals received from the FEM circuitry 908 and provide baseband signals to the baseband circuitry 904. The RF circuitry 906 may also include a transmit signal path which may include circuitry to up-convert baseband signals provided by the baseband circuitry 904 and provide RF output signals to the FEM circuitry 908 for transmission.

In some embodiments, the receive signal path of the RF circuitry 906 may include mixer circuitry 906a, amplifier circuitry 906b and filter circuitry 906c. In some embodiments, the transmit signal path of the RF circuitry 906 may include filter circuitry 906c and mixer circuitry 906a. The RF circuitry 906 may also include synthesizer circuitry 906d for synthesizing a frequency, or component carrier, for use by the mixer circuitry 906a and/or the N-path circuitry 906E of the receive signal path and the transmit signal path. In some embodiments, the mixer circuitry 906a of the receive signal path may to down-convert RF signals received from the FEM circuitry 908 based on the synthesized frequency provided by synthesizer circuitry 906d. The amplifier circuitry 906b may amplify the down-converted signals and the filter circuitry 906c may be a low-pass filter (LPF) or band-pass filter (BPF) to remove unwanted signals from the down-converted signals to generate output baseband signals. Output baseband signals may be provided to the baseband circuitry 904 for further processing.

In some embodiments, the output baseband signals may be zero-frequency baseband signals, although this is not a requirement. In some embodiments, mixer circuitry 906a of the receive signal path may comprise passive mixers, although the scope of the embodiments is not limited in this respect.

In some embodiments, the mixer circuitry 906a of the transmit signal path may be configured to up-convert input baseband signals based on the synthesized frequency provided by the synthesizer circuitry 906d to generate RF output signals for the FEM circuitry 908. The baseband signals may be provided by the baseband circuitry 904 and may be filtered by filter circuitry 906c.

In some embodiments, the mixer circuitry 906a of the receive signal path and the mixer circuitry 906a of the transmit signal path may include two or more mixers and may be arranged for quadrature downconversion and upconversion, respectively. In some embodiments, the mixer circuitry 906a of the receive signal path and the mixer circuitry 906a of the transmit signal path may include two or more mixers and may be arranged for image rejection (e.g., Hartley image rejection). In some embodiments, the mixer circuitry 906a of the receive signal path and the mixer circuitry 906a may be arranged for direct downconversion and direct upconversion, respectively. In some embodiments, the mixer circuitry 906a of the receive signal path and the mixer circuitry 906a of the transmit signal path may be configured for super-heterodyne operation.

In some embodiments, the output baseband signals and the input baseband signals may be analog baseband signals, although the scope of the embodiments is not limited in this respect. In some alternate embodiments, the output baseband signals and the input baseband signals may be digital baseband signals. In these alternate embodiments, the RF circuitry 906 may include analog-to-digital converter (ADC) and digital-to-analog converter (DAC) circuitry and the baseband circuitry 904 may include a digital baseband interface to communicate with the RF circuitry 906.

In some dual-mode embodiments, a separate radio IC circuitry may be provided for processing signals for each spectrum, although the scope of the embodiments is not limited in this respect.

In some embodiments, the synthesizer circuitry 906d may be a fractional-N synthesizer or a fractional $N/N+1$ synthesizer, although the scope of the embodiments is not limited in this respect as other types of frequency synthesizers may be suitable. For example, synthesizer circuitry 906d may be a delta-sigma synthesizer, a frequency multiplier, or a synthesizer comprising a phase-locked loop with a frequency divider.

The synthesizer circuitry 906d may synthesize an output frequency for use by the mixer circuitry 906a and the N-path filter circuitry 906E of the RF circuitry 906 based on one or more frequency inputs and one or more divider control inputs. In some embodiments, the synthesizer circuitry 906d may be a fractional $N/N+1$ synthesizer.

In some embodiments, frequency input may be an output of a voltage-controlled oscillator (VCO), although that is not a requirement. Divider control input may be an output of either the baseband circuitry 904 or an application processor of the applications circuitry 902 depending on the desired output frequency. Some embodiments may determine a divider control input (e.g., N) from a look-up table based on a channel indicated by the applications circuitry 902.

The synthesizer circuitry 906d of the RF circuitry 906 may include a divider, a delay-locked loop (DLL), a multiplexer and a phase accumulator. In some embodiments, the divider may be a dual modulus divider (DMD) and the phase accumulator may be a digital phase accumulator (DPA). In some embodiments, the DMD may be configured to divide the input signal by either N or N+1 (e.g., based on a carry out) to provide a fractional division ratio. In some example embodiments, the DLL may include a set of cascaded, tunable, delay elements, a phase detector, a charge pump and a D-type flip-flop. In these embodiments, the delay elements may break a VCO period up into Nd equal packets of phase, where Nd is the number of delay elements in the delay line. In this way, the DLL provides negative feedback to help ensure that the total delay through the delay line is one VCO cycle.

In some embodiments, the synthesizer circuitry 906d may generate a carrier frequency (or component carrier) as the output frequency, while in other embodiments, the output frequency may be a multiple of the carrier frequency (e.g., twice the carrier frequency, four times the carrier frequency) and used in conjunction with quadrature generator and divider circuitry to generate multiple signals at the carrier frequency with multiple different phases with respect to each other. In some embodiments, the output frequency may be a local oscillator (LO) frequency (fLO). In some embodiments, the RF circuitry 906 may include an IQ/polar converter.

The FEM circuitry 908 may include a receive signal path which may include circuitry to operate on RF signals received from one or more antennas 910, amplify the received signals and provide the amplified versions of the received signals to the RF circuitry 906 for further processing. FEM circuitry 908 may also include a transmit signal path which may include circuitry configured to amplify signals for transmission provided by the RF circuitry 906 for transmission by one or more of the one or more antennas 910. In various embodiments, the amplification through the transmit or receive signal paths may be done solely in the RF circuitry 906, solely in the FEM circuitry 908, or in both the RF circuitry 906 and the FEM circuitry 908.

In some embodiments, the FEM circuitry 908 may include a TX/RX switch to switch between transmit mode and receive mode operation. The FEM circuitry may include a receive signal path and a transmit signal path. The receive signal path of the FEM circuitry may include a low-noise amplifier (LNA) to amplify received RF signals and provide the amplified received RF signals as an output (e.g., to the RF circuitry 906). The transmit signal path of the FEM circuitry 908 may include a power amplifier (PA) to amplify input RF signals (e.g., provided by RF circuitry 906), and one or more filters to generate RF signals for subsequent transmission (e.g., by one or more of the one or more antennas 910).

In the present embodiment, the radio refers to a combination of the RF circuitry 906 and the FEM circuitry 908. The radio refers to the portion of the circuitry that generates and transmits or receives and processes the radio signals. The RF circuitry 906 includes a transmitter to generate the time domain radio signals with the data from the baseband signals and apply the radio signals to subcarriers of the carrier frequency that form the bandwidth of the channel. The PA in the FEM circuitry 908 amplifies the tones for transmission and may, in some embodiments, amplify tones received from the one or more antennas 910 via the LNA to increase the signal-to-noise ratio (SNR) for interpretation. In wireless communications, the FEM circuitry 908 may also search for a detectable pattern that appears to be a wireless communication. Thereafter, a receiver in the RF circuitry 906 converts the time domain radio signals to baseband signals via one or more functional modules such as the functional modules shown in the base station or access network (AN) and the user equipment (UE) illustrated and discussed in FIG. 11.

In some embodiments, the PMC 912 may manage power provided to the baseband circuitry 904. In particular, the PMC 912 may control power-source selection, voltage scaling, battery charging, or DC-to-DC conversion. The PMC 912 may often be included when the device 900 is capable of being powered by a battery, for example, when the device is included in a UE. The PMC 912 may increase the power conversion efficiency while providing desirable implementation size and heat dissipation characteristics.

While FIG. 9 shows the PMC 912 coupled only with the baseband circuitry 904. However, in other embodiments, the PMC 912 may be additionally or alternatively coupled with, and perform similar power management operations for, other components such as, but not limited to, application circuitry 902, RF circuitry 906, or FEM circuitry 908.

In some embodiments, the PMC 912 may control, or otherwise be part of, various power saving mechanisms of the device 900. For example, if the device 900 is in an RRC_Connected state, where it is still connected to the RAN node as it expects to receive traffic shortly, then it may enter a state known as Discontinuous Reception Mode (DRX) after a period of inactivity. During this state, the device 900 may power down for brief intervals of time and thus save power.

If there is no data traffic activity for an extended period of time, then the device 900 may transition off to an RRC Idle state, where it disconnects from the network and does not perform operations such as channel quality feedback, handover, etc. The device 900 goes into a very low power state and it performs paging where again it periodically wakes up to listen to the network and then powers down again. The device 900 may not receive data in this state, in order to receive data, it must transition back to RRC Connected state.

An additional power saving mode may allow a device to be unavailable to the network for periods longer than a paging interval (ranging from seconds to a few hours). During this time, the device is totally unreachable to the network and may power down completely. Any data sent during this time incurs a large delay and it is assumed the delay is acceptable.

The processors of the application circuitry 902 and the processors of the baseband circuitry 904 may be used to execute elements of one or more instances of a protocol stack. For example, processors of the baseband circuitry 904, alone or in combination, may be used execute Layer 3, Layer 2, or Layer 1 functionality, while processors of the application circuitry 902 may utilize data (e.g., packet data) received from these layers and further execute Layer 4 functionality (e.g., transmission communication protocol (TCP) and user datagram protocol (UDP) layers). As referred to herein, Layer 3 may comprise a radio resource control (RRC) layer, described in further detail below. As referred to herein, Layer 2 may comprise a medium access control (MAC) layer, a radio link control (RLC) layer, and a packet data convergence protocol (PDCP) layer, described in further detail below. As referred to herein, Layer 1 may comprise a physical (PHY) layer of a UE/RAN node, described in further detail below.

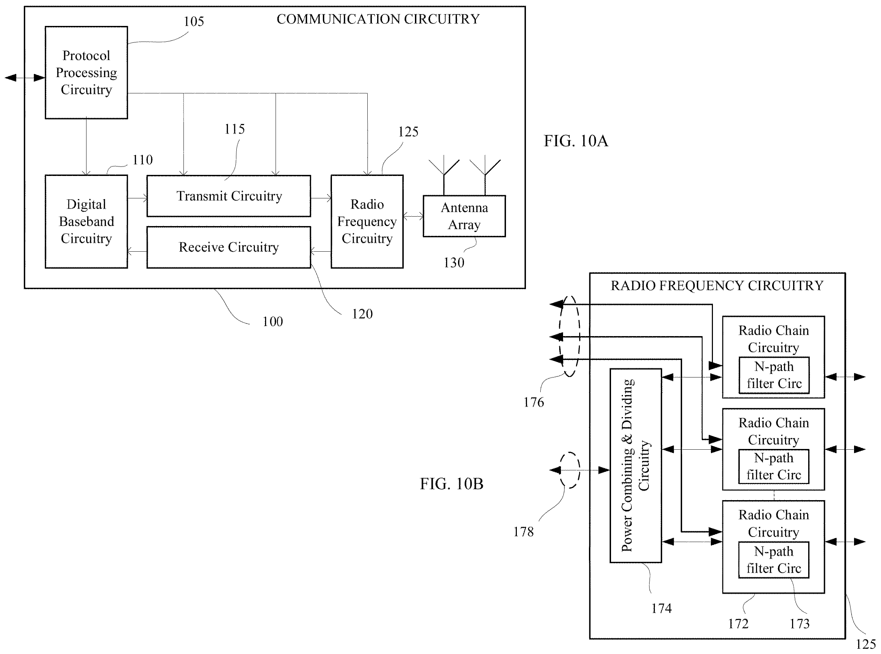

**FIG. 10A** illustrates an embodiment of communication circuitry 100 such as the circuitry in the ANs and the user equipment shown in FIG. 11. The communication circuitry 100 is alternatively grouped according to functions. Components as shown in the communication circuitry 100 are shown here for illustrative purposes and may include other components not shown here in Fig. 10A.

The communication circuitry 100 may include protocol processing circuitry 105, which may implement one or more of medium access control (MAC), radio link control (RLC), packet data convergence protocol (PDCP), radio resource control (RRC) and non-access stratum (NAS) functions. The protocol processing circuitry 105 may include one or more processing cores (not shown) to execute instructions and one or more memory structures (not shown) to store program (code) and data information.

The communication circuitry 100 may further include digital baseband circuitry 110, which may implement physical layer (PHY) functions including one or more of hybrid automatic repeat request (HARQ) functions, scrambling and/or descrambling, coding and/or decoding, layer mapping and/or de-mapping, modulation symbol mapping, received symbol and/or bit metric determination, multi-antenna port pre-coding and/or decoding which may include one or more of space-time, space-frequency or spatial coding, reference signal generation and/or detection, preamble sequence generation and/or decoding, synchronization sequence generation and/or detection, control channel signal blind decoding, and other related functions.

The communication circuitry 100 may further include transmit circuitry 115, receive circuitry 120 and/or antenna array 130 circuitry.

The communication circuitry 100 may further include radio frequency (RF) circuitry 125 such as the RF circuitry 125 in FIG. 10B. In an aspect of an embodiment, RF circuitry 125 may include multiple parallel RF chains for one or more of transmit or receive functions, each connected to one or more antennas of the antenna array 130.

In an aspect of the disclosure, the protocol processing circuitry 105 may include one or more instances of control circuitry (not shown) to provide control functions for one or more of digital baseband circuitry 110, transmit circuitry 115, receive circuitry 120, and/or radio frequency circuitry 125.

**FIG. 10B** illustrates an embodiment of radio frequency circuitry 125 in FIG. 10A according to some aspects such as a RF circuitry or radio illustrated in FIGs. 1A-H, 2A-2B, 3, 5-6, and 9. The radio frequency circuitry 125 may include one or more instances of radio chain circuitry 172, which in some aspects may include one or more filters, power amplifiers, low noise amplifiers, programmable phase shifters and power supplies (not shown). In some embodiments, the radio frequency circuitry 125 may comprise N-path filter circuitry 173 in the radio chain circuitry 172 such as the N-path filter circuitry 1006 in FIGs 1A and 1C and may also implement baseband shunt-feedback amplifiers coupled with the output of the N-path filter circuitry such as the baseband shunt-feedback amplifiers 1008 in FIGs 1A and 1C. In some embodiments, an input of the N-path filter circuitry 1006 may couple an LNA in the radio chain circuitry 172 such as shown in FIG. 1A. In other embodiments, the input of the N-path filter circuitry 1006 may couple an antenna such as shown in FIG. 1C and the output of a baseband amplifier may couple with A/D converters in receive circuitry 115 or in the digital baseband circuitry 110 shown in FIG. 10A.

The radio frequency circuitry 125 may include power combining and dividing circuitry 174. In some aspects, power combining and dividing circuitry 174 may operate bidirectionally, such that the same physical circuitry may be configured to operate as a power divider when the device is transmitting, and as a power combiner when the device is receiving. In some aspects, power combining and dividing circuitry 174 may one or more include wholly or partially separate circuitries to perform power dividing when the device is transmitting and power combining when the device is receiving. In some aspects, power combining and dividing circuitry 174 may include passive circuitry comprising one or more two-way power divider/combiners arranged in a tree. In some aspects, power combining and dividing circuitry 174 may include active circuitry comprising amplifier circuits.

In some aspects, the radio frequency circuitry 125 may connect to transmit circuitry 115 and receive circuitry 120 in FIG. 10A via one or more radio chain interfaces 176 or a combined radio chain interface 178. The combined radio chain interface 178 may form a wide or very wide bandwidth.

In some aspects, one or more radio chain interfaces 176 may provide one or more interfaces to one or more receive or transmit signals, each associated with a single antenna structure which may comprise one or more antennas.

In some aspects, the combined radio chain interface 178 may provide a single interface to one or more receive or transmit signals, each associated with a group of antenna structures comprising one or more antennas.

**FIG. 11** illustrates an architecture of a system 1100 of a network in accordance with some embodiments. The system 1100 is shown to include a user equipment (UE) 1101 and a UE 1102 such as the UEs shown in FIGs. 1A-1B, and 2. The UEs 1101 and 1102 are illustrated as smartphones (e.g., handheld touch screen mobile computing devices connectable to one or more cellular networks) but may also comprise any mobile or non-mobile computing device, such as Personal Data Assistants (PDAs), pagers, laptop computers, desktop computers, wireless handsets, or any computing device including a wireless communications interface.

In some embodiments, any of the UEs 1101 and 1102 can comprise an Internet of Things (IoT) UE, which can comprise a network access layer designed for low-power IoT applications utilizing short-lived UE connections. In many embodiments, the UEs 1101 and 1102 may implement N-path filter circuitry such as the N-path filter circuitry 1006 in FIGs 1A and 1C and may also implement baseband shunt-feedback amplifiers coupled with the output of the N-path filter circuitry such as the baseband shunt-feedback amplifiers 1008 in FIGs 1A and 1C.

The N-path filter circuitry may couple with an output of an LNA or couple between an antenna and a mixer in a mixer first receiver to provide RF selectivity up to 80dB/decade with tunable RF filtering. Some embodiments may implement the N-path filter circuitry in a receiver for cellular communications. Some embodiments may implement the N-path filter circuitry in a receiver for WiFi communications. Some embodiments may implement the N-path filter circuitry in a receiver for cellular communications. Some embodiments may implement the N-path filter circuitry in a receiver for Bluetooth® communications. And some embodiments may implement the N-path filter circuitry in any combination of one or more receivers for cellular communications, WiFi communications, Bluetooth® communications, and/or other wireless communication protocols.

An IoT UE can utilize technologies such as machine-to-machine (M2M) or machine-type communications (MTC) for exchanging data with an MTC server or device via a public land mobile network (PLMN), Proximity-Based Service (ProSe) or device-to-device (D2D) communication, sensor networks, or IoT networks. The M2M or MTC exchange of data may be a machine-initiated exchange of data. An IoT network describes interconnecting IoT UEs, which may include uniquely identifiable embedded computing devices (within the Internet infrastructure), with short-lived connections. The IoT UEs may execute background applications (e.g., keep-alive messages, status updates, etc.) to facilitate the connections of the IoT network.

The UEs 1101 and 1102 may to connect, e.g., communicatively couple, with a radio access network (RAN) - in this embodiment, an Evolved Universal Mobile Telecommunications System (UMTS) Terrestrial Radio Access Network (E-UTRAN) 1110. In some embodiments, the access nodes (ANs) in the cellular network such as the RANs may implement N-path filter circuitry such as the N-path filter circuitry 1006 in FIGs 1A and 1C and may also implement baseband shunt-feedback amplifiers coupled with the output of the N-path filter circuitry such as the baseband shunt-feedback amplifiers 1008 in FIGs 1A and 1C.

The UEs 1101 and 1102 utilize connections 1103 and 1104, respectively, each of which comprises a physical communications interface or layer (discussed in further detail below); in this example, the connections 1103 and 1104 are illustrated as an air interface to enable communicative coupling, and can be consistent with cellular communications protocols, such as a Global System for Mobile Communications (GSM) protocol, a code-division multiple access (CDMA) network protocol, a Push-to-Talk (PTT) protocol, a PTT over Cellular (POC) protocol, a Universal Mobile Telecommunications System (UMTS) protocol, a 3GPP Long Term Evolution (LTE) protocol, a fifth generation (5G) protocol, a New Radio (NR) protocol, and the like.

In this embodiment, the UEs 1101 and 1102 may further directly exchange communication data via a ProSe interface 1105. The ProSe interface 1105 may alternatively be referred to as a sidelink interface comprising one or more logical channels, including but not limited to a Physical Sidelink Control Channel (PSCCH), a Physical Sidelink Shared Channel (PSSCH), a Physical Sidelink Discovery Channel (PSDCH), and a Physical Sidelink Broadcast Channel (PSBCH).

The UE 1102 is shown to be configured to access an access point (AP) 1106 via connection 1107. The connection 1107 can comprise a local wireless connection, such as a connection consistent with any IEEE 802.11 protocol, wherein the AP 1106 would comprise a wireless fidelity (WiFi®) router. In this example, the AP 1106 is shown to be connected to the Internet without connecting to the core network of the wireless system (described in further detail below). In some embodiments, the access points (APs) in a WiFi network or in the cellular network may implement N-path filter circuitry such as the N-path filter circuitry 1006 in FIGs 1A and 1C and may also implement baseband shunt-feedback amplifiers coupled with the output of the N-path filter circuitry such as the baseband shunt-feedback amplifiers 1008 in FIGs 1A and 1C.

The E-UTRAN 1110 can include one or more access nodes that enable the connections 1103 and 1104. These ANs can be referred to as base stations (BSs), NodeBs, evolved NodeBs (eNBs), next Generation NodeBs (gNB), RAN nodes, and so forth, and can comprise ground stations (e.g., terrestrial access points) or satellite stations providing coverage within a geographic area (e.g., a cell). The E-UTRAN 1110 may include one or more RAN nodes for providing macro-cells, e.g., macro RAN node 1111, and one or more RAN nodes for providing femto-cells or picocells (e.g., cells having smaller coverage areas, smaller user capacity, or higher bandwidth compared to macro-cells), e.g., low power (LP) RAN node 1112.

Any of the RAN nodes 1111 and 1112 can terminate the air interface protocol and can be the first point of contact for the UEs 1101 and 1102. In some embodiments, any of the RAN nodes 1111 and 1112 can fulfill various logical functions for the E-UTRAN 1110 including, but not limited to, radio network controller (RNC) functions such as radio bearer management, uplink and downlink dynamic radio resource management and data packet scheduling, and mobility management.

In accordance with some embodiments, the UEs 1101 and 1102 can be configured to communicate using Orthogonal Frequency-Division Multiplexing (OFDM) communication signals with each other or with any of the RAN nodes 1111 and 1112 over a multicarrier communication channel in accordance various communication techniques, such as, but not limited to, an Orthogonal Frequency-Division Multiple Access (OFDMA) communication technique (e.g., for downlink communications) or a Single Carrier Frequency Division Multiple Access (SC-FDMA) communication technique (e.g., for uplink and ProSe or sidelink communications), although the scope of the embodiments is not limited in this respect. The OFDM signals can comprise a plurality of orthogonal subcarriers.

In some embodiments, a downlink resource grid can be used for downlink transmissions from any of the RAN nodes 1111 and 1112 to the UEs 1101 and 1102, while uplink transmissions can utilize similar techniques. The grid can be a time-frequency grid, called a resource grid or time-frequency resource grid, which is the physical resource in the downlink in each slot. Such a time-frequency plane representation is a common practice for OFDM systems, which makes it intuitive for radio resource allocation. Each column and each row of the resource grid corresponds to one OFDM symbol and one OFDM subcarrier, respectively. The duration of the resource grid in the time domain corresponds to one slot in a radio frame. The smallest time-frequency unit in a resource grid is denoted as a resource element. Each resource grid comprises a number of resource blocks, which describe the mapping of certain physical channels to resource elements. Each resource block comprises a collection of resource elements; in the frequency domain, this may represent the smallest quantity of resources that currently can be allocated. There are several different physical downlink (DL) channels that are conveyed using such resource blocks.

The physical downlink shared channel (PDSCH) may carry user data and higher-layer signaling to the UEs 1101 and 1102. The physical downlink control channel (PDCCH) may carry information about the transport format and resource allocations related to the PDSCH channel, among other things. It may also inform the UEs 1101 and 1102 about the transport format, resource allocation, and HARQ (Hybrid Automatic Repeat Request) information related to the uplink shared channel. Typically, downlink scheduling (assigning control and shared channel resource blocks to the UE 102 within a cell) may be performed at any of the RAN nodes 1111 and 1112 based on channel quality information fed back from any of the UEs 1101 and 1102. The downlink resource assignment information may be sent on the PDCCH used for (e.g., assigned to) each of the UEs 1101 and 1102.

The PDCCH may use control channel elements (CCEs) to convey the control information. Before being mapped to resource elements, the PDCCH complex-valued symbols may first be organized into quadruplets, which may then be permuted using a sub-block interleaver for rate matching. Each PDCCH may be transmitted using one or more of these CCEs, where each CCE may correspond to nine sets of four physical resource elements known as resource element groups (REGs). Four Quadrature Phase Shift Keying (QPSK) symbols may be mapped to each REG. The PDCCH can be transmitted using one or more CCEs, depending on the size of the downlink control information (DCI) and the channel condition. There can be four or more different PDCCH formats defined in LTE with different numbers of CCEs (e.g., aggregation level, L=l, 2, 4, or 8).

Some embodiments may use concepts for resource allocation for control channel information that are an extension of the above-described concepts. For example, some embodiments may utilize an enhanced physical downlink control channel (EPDCCH) that uses PDSCH resources for control information transmission. The EPDCCH may be transmitted using one or more enhanced the control channel elements (ECCEs). Similar to above, each ECCE may correspond to nine sets of four physical resource elements known as an enhanced resource element groups (EREGs). An ECCE may have other numbers of EREGs in some situations.

The RAN nodes 1111 and 1112 may communicate with one another and/or with other access nodes in the E-UTRAN 1110 and/or in another RAN via an X2 interface, which is a signaling interface for communicating data packets between ANs. Some other suitable interface for communicating data packets directly between ANs may be used.

The E-UTRAN 1110 is shown to be communicatively coupled to a core network - in this embodiment, an Evolved Packet Core (EPC) network 1120 via an SI interface 1113. In this embodiment the SI interface 1113 is split into two parts: the SI-U interface 1114, which carries traffic data between the RAN nodes 1111 and 1112 and the serving gateway (S-GW) 1122, and the SI-mobility management entity (MME) interface 1115, which is a signaling interface between the RAN nodes 1111 and 1112 and MMEs 1121.

In this embodiment, the EPC network 1120 comprises the MMEs 1121, the S-GW 1122, the Packet Data Network (PDN) Gateway (P-GW) 1123, and a home subscriber server (HSS) 1124. The MMEs 1121 may be similar in function to the control plane of legacy Serving General Packet Radio Service (GPRS) Support Nodes (SGSN). The MMEs 1121 may manage mobility aspects in access such as gateway selection and tracking area list management. The HSS 1124 may comprise a database for network users, including subscription-related information to support the network entities' handling of communication sessions. The EPC network 1120 may comprise one or several HSSs 1124, depending on the number of mobile subscribers, on the capacity of the equipment, on the organization of the network, etc. For example, the HSS 1124 can provide support for routing/roaming, authentication, authorization, naming/addressing resolution, location dependencies, etc.

The S-GW 1122 may terminate the SI interface 1113 towards the E-UTRAN 1110, and routes data packets between the E-UTRAN 1110 and the EPC network 1120. In addition, the S-GW 1122 may be a local mobility anchor point for inter-RAN node handovers and also may provide an anchor for inter-3GPP mobility. Other responsibilities may include lawful intercept, charging, and some policy enforcement.

The P-GW 1123 may terminate an SGi interface toward a PDN. The P-GW 1123 may route data packets between the EPC network 1120 and external networks such as a network including the application server 1130 (alternatively referred to as application function (AF)) via an Internet Protocol (IP) interface 1125. Generally, the application server 1130 may be an element offering applications that use IP bearer resources with the core network (e.g., UMTS Packet Services (PS) domain, LTE PS data services, etc.). In this embodiment, the P-GW 1123 is shown to be communicatively coupled to an application server 1130 via an IP interface 1125. The application server 1130 can also be configured to support one or more communication services (e.g., Voice-over-Internet Protocol (VoIP) sessions, PTT sessions, group communication sessions, social networking services, etc.) for the UEs 1101 and 1102 via the EPC network 1120.

The P-GW 1123 may further be a node for policy enforcement and charging data collection. Policy and Charging Enforcement Function (PCRF) 1126 is the policy and charging control element of the EPC network 1120. In a non-roaming scenario, there may be a single PCRF in the Home Public Land Mobile Network (HPLMN) associated with a UE's Internet Protocol Connectivity Access Network (IP-CAN) session. In a roaming scenario with local breakout of traffic, there may be two PCRFs associated with a UE's IP-CAN session: a Home PCRF (H-PCRF) within a HPLMN and a Visited PCRF (V-PCRF) within a Visited Public Land Mobile Network (VPLMN). The PCRF 1126 may be communicatively coupled to the application server 1130 via the P-GW 1123. The application server 1130 may signal the PCRF 1126 to indicate a new service flow and select the appropriate Quality of Service (QoS) and charging parameters. The PCRF 1126 may provision this rule into a Policy and Charging Enforcement Function (PCEF) (not shown) with the appropriate traffic flow template (TFT) and QoS class of identifier (QCI), which commences the QoS and charging as specified by the application server 1130.

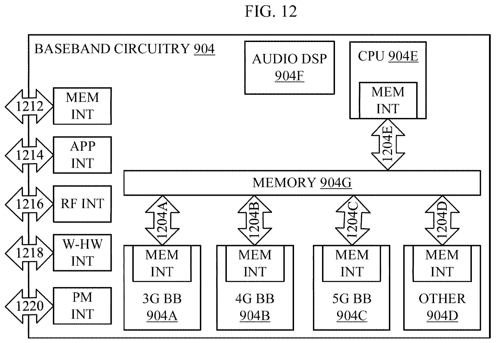

FIG. 12 illustrates example interfaces of baseband circuitry in accordance with some embodiments such as the baseband circuitry shown in FIGs. 2A, 2B, 2G, 3, and 9. As discussed above, the baseband circuitry 904 of FIG. 9 may comprise processors 904A-904E and a memory 904G utilized by said processors. Each of the processors 904A-904E may include a memory interface, 1204A-1204E, respectively, to send/receive data to/from the memory 904G.

The baseband circuitry 904 may further include one or more interfaces to communicatively couple to other circuitries/devices, such as a memory interface 1212 (e.g., an interface to send/receive data to/from memory external to the baseband circuitry 904), an application circuitry interface 1214 (e.g., an interface to send/receive data to/from the application circuitry 902 of FIG. 9), an RF circuitry interface 1216 (e.g., an interface to send/receive data to/from RF circuitry 906 of FIG. 9), a wireless hardware connectivity interface 1218 (e.g., an interface to send/receive data to/from Near Field Communication (NFC) components, Bluetooth® components (e.g., Bluetooth® Low Energy), Wi-Fi® components, and other communication components), and a power management interface 1220 (e.g., an interface to send/receive power or control signals to/from the PMC 912. In some embodiments, RF circuitry interface 1216 may couple with N-path filter circuitry such as the N-path filter circuitry 1006 in FIGs 1A and 1C via baseband amplifiers such as the baseband shunt-feedback amplifiers coupled with the output of the N-path filter circuitry such as the baseband shunt-feedback amplifiers 1008 in FIGs 1A and 1C.

One or more aspects of at least one example may comprise representative instructions stored on at least one machine-readable medium which represents various logic within the processor, which when read by a machine, computing device or system causes the machine, computing device or system to fabricate logic to perform the techniques described herein. Such representations, known as "IP cores" may be stored on a tangible, machine readable medium and supplied to various customers or manufacturing facilities to load into the fabrication machines that make the logic or processor.

Some examples may include an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or non-removable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner, or syntax, for instructing a machine, computing device or system to perform a certain function. The instructions may be implemented using any suitable high-level, low-level, object-oriented, visual, compiled and/or interpreted programming language.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.

ADVANTAGES OF SOME EMBODIMENTS

Several embodiments have one or more potentially advantages effects. For instance, the N-path filter circuitry provides as high as 80dB/decade tunable RF filtering. The center-frequency of the filter can be tuned by tuning the frequency of the LO which drives the N-path filter. This potentially act as a replacement for bulky BAW-filter-based solutions due to its tunable yet superior RF filtering. Furthermore, the N-path filter circuitry can be combined with distortion cancellation techniques to eliminate distortion generated by the transistors used for impedance synthesis, thereby yielding distortion-free higher-order RF filtering.

EXAMPLES OF FURTHER EMBODIMENTS

The following examples pertain to further embodiments. Specifics in the examples may be used anywhere in one or more embodiments.

Example 1 is an apparatus comprising at least one input transistor, wherein the at least one input transistor comprises a channel and a gate, wherein a first end of the channel is coupled with a receiver circuitry input, wherein a second end of the channel is coupled with a load, wherein the gate of the at least one input transistor is coupled with a clock circuitry input; and the load comprising a fourth order, all-pole driving point impedance, the impedance to shunt the second end of the channel to a circuit ground or a low voltage circuit rail via the impedance, wherein the impedance comprises a first active impedance circuit coupled in series with a second active impedance circuit, the second active impedance circuit having a transfer function equivalent to a parallel combination of a negative resistance, a negative inductance, and a negative capacitance. In Example 2, the apparatus of Example 1, further comprising receiver circuitry coupled with the receiver circuitry input, the receiver circuitry to output energy for a wireless communication signal. In Example 3, the apparatus of Example 2, wherein the receiver circuitry comprises an antenna coupled with the output of the receiver circuitry. In Example 4, the apparatus of Example 2, wherein the receiver circuitry comprises a duplexer coupled with the output of the receiver circuitry. In Example 5, the apparatus of Example 2, wherein the receiver circuitry comprises a low noise amplifier coupled with the output of the receiver circuitry. In Example 6, the apparatus of Example 1, further comprising clock circuitry coupled with the clock circuitry input, the clock circuitry to output a set of clock pulses, wherein each clock pulse of the set of clock pulses has a duty cycle, wherein each clock pulse of the set of clock pulses has a period tuned to a period of a carrier frequency of the wireless communication signal. In Example 7, the apparatus of Example 6, wherein the clock circuitry comprises a local oscillator, synthesizer circuitry, or a combination of a local oscillator and synthesizer circuitry. In Example 8, the apparatus of Example 6, wherein the set of clock pulses comprises four clock pulses, the clock circuitry to apply a 25 percent duty cycle to each of the four clock pulses, wherein a combination of periods of the set of the clock pulses comprises a full period of the period of the carrier frequency of the wireless communication signal. In Example 9, the apparatus of Example 8, wherein application of one clock pulse of the set of clock pulses to the gate of the input transistor enables the energy of the wireless communication signal to traverse the channel to the load during 25 percent of the period of the carrier frequency. In Example 10, the apparatus of Example 6, wherein the at least one transistor comprises four transistors, wherein each of the four transistors couples with a distinct impedance shunted to a circuit ground or a low voltage rail, wherein each distinct impedance comprises a fourth order, all-pole driving point impedance, each distinct impedance to receive the energy of the wireless communication signal during a different portion of the period of the carrier frequency of the wireless communication signal based on the set of clock pulses. In Example 11, the apparatus of Example 1, wherein the second active impedance circuit comprising a negative inductance synthesized by a gyrator with differential mode positive feedback. In Example 12, the apparatus of Example 1, wherein the second active impedance circuit comprises a negative resistance-capacitance amplifier circuit, wherein the negative resistance-capacitance amplifier circuit comprises a set of four transistors, wherein each of two of the set of four transistors comprises a parallel combination of a resistance and a capacitance coupled between a gate and a source. In Example 13, the apparatus of Example 1, wherein the second active impedance circuit comprises a bias transistor shunted to the circuit ground or a low voltage circuit rail to reduce distortion associated with amplifier circuitry of the first active impedance circuit. In Example 14, the apparatus of Example 10, wherein the first active impedance circuit comprises a first active impedance transistor coupled in parallel with a first capacitance, wherein the first active impedance transistor comprises a first resistance coupled between a source and a gate of the first active impedance transistor and a second capacitance coupled between the gate and a drain of the first active impedance transistor.

Example 15 is a system comprising receiver circuitry comprising an output, the receiver circuitry to apply, to the output, energy received via a wireless communication signal; clock circuitry comprising a set of outputs, the clock circuitry to apply a different clock pulse of a set of clock pulses to each output of the set of outputs, wherein each clock pulse of the set of clock pulses has a duty cycle, wherein each clock pulse of the set of clock pulses has a period related to a period of a carrier frequency of the wireless communication signal; a set of fourth order, all-pole driving point impedances, wherein each impedance comprises an input that is shunt to a circuit ground or a low voltage circuit rail via the impedance; and a set of transistors, wherein each transistor of the set of transistors comprises a channel and a gate, wherein a first end of the channel is coupled with the output of the receiver circuitry to receive the energy, wherein a second end of the channel of each transistor of the set of transistors is coupled with the input of a different impedance of the set of fourth order, all-pole driving point impedances, wherein the gate of each transistor of the set of transistors is coupled with a different output of the set of outputs of the clock circuitry. In Example 16, the system of Example 15, further comprising baseband sunt-feedback amplifiers coupled with the set of transistors to receive in-phase (I) and quadrature (Q) signals from the set of fourth order, all-pole driving point impedances. In Example 17, the system of Example 15, wherein the receiver circuitry comprises an antenna coupled with the output of the receiver circuitry, a duplexer coupled with the output of the receiver circuitry, or a low noise amplifier coupled with the output of the receiver circuitry. In Example 18, the system of Example 15, wherein the clock circuitry comprises a local oscillator, synthesizer circuitry, or a combination of a local oscillator and synthesizer circuitry. In Example 19, the system of Example 15, wherein each impedance of the set of fourth order, all-pole driving point impedances receives the energy of the wireless communication signal during a different portion of the period of the carrier frequency of the wireless communication signal. In Example 20, the system of Example 15, wherein each impedance of the set of fourth order, all-pole driving point impedances comprises a first active impedance circuit coupled in series with a second active impedance circuit, wherein the second active impedance is shunted to the circuit ground and the first active impedance is coupled with the second end of the channel of one transistor of the set of transistors.

Example 21 is a method to perform any one or more of Examples 1 through 20.

Example 22 is an apparatus comprising a means for performing any one or more of Examples 1 through 20.

Example 23 is an apparatus comprising a fourth order, all-pole driving point impedance, the impedance to shunt an input to a circuit ground via the impedance, wherein the impedance comprises: a first active impedance circuit and a second active impedance circuit coupled in series with the first active impedance circuit, the second active impedance circuit having a transfer function equivalent to a parallel combination of a negative resistance, a negative inductance, and a negative capacitance. In Example 24, the system of claim 23, wherein the first active impedance circuit comprises a first active impedance transistor coupled in parallel with a first capacitance, wherein the first active impedance transistor comprises a first resistance coupled between a source and a gate of the first active impedance transistor and a second capacitance coupled between the gate and a drain of the first active impedance transistor. In Example 25, the system of claim 23, the second active impedance circuit comprising a negative inductance synthesized by a gyrator with differential mode positive feedback. In Example 26, the system of claim 23, wherein the second active impedance circuit comprises a negative resistance-capacitance amplifier circuit, wherein the negative resistance-capacitance amplifier circuit comprises a set of four transistors, wherein each of two of the set of four transistors comprises a parallel combination of a resistance and a capacitance coupled between a gate and a source. In Example 27, the system of any claim 21-26, wherein the second active impedance circuit comprises a bias transistor shunted to the circuit ground or a low voltage circuit rail to reduce distortion associated with amplifier circuitry of the first active impedance circuit.

## Claims

1.   An apparatus comprising:

at least one input transistor, wherein the at least one input transistor comprises a channel and a gate, wherein a first end of the channel is coupled with a receiver circuitry input, wherein a second end of the channel is coupled with a load, wherein the gate of the at least one input transistor is coupled with a clock circuitry input; and
the load comprising a fourth order, all-pole driving point impedance, the impedance to shunt the second end of the channel to a circuit ground or a low voltage circuit rail via the impedance, wherein the impedance comprises a first active impedance circuit coupled in series with a second active impedance circuit, the second active impedance circuit having a transfer function equivalent to a parallel combination of a negative resistance, a negative inductance, and a negative capacitance.

2.   The apparatus of claim 1, further comprising receiver circuitry coupled with the receiver circuitry input, the receiver circuitry to output energy for a wireless communication signal, wherein the receiver circuitry comprises an antenna coupled with an output of the receiver circuitry, a duplexer coupled with the output of the receiver circuitry, or a low noise amplifier coupled with the output of the receiver circuitry.

3.   The apparatus of claim 2, further comprising clock circuitry coupled with the clock circuitry input, the clock circuitry to output a set of clock pulses, wherein each clock pulse of the set of clock pulses has a duty cycle, wherein each clock pulse of the set of clock pulses has a period tuned to a period of a carrier frequency of the wireless communication signal.

4. The apparatus of claim 3, wherein the clock circuitry comprises a local oscillator, synthesizer circuitry, or a combination of a local oscillator and synthesizer circuitry.

5. The apparatus of claim 3 or 4, wherein the set of clock pulses comprises four clock pulses, the clock circuitry to apply a 25 percent duty cycle to each of the four clock pulses, wherein a combination of periods of the set of clock pulses comprises a full period of the period of the carrier frequency of the wireless communication signal.

6. The apparatus of claim 5, wherein application of one clock pulse of the set of clock pulses to the gate of the input transistor enables the energy of the wireless communication signal to traverse the channel to the load during 25 percent of the period of the carrier frequency.

7. The apparatus of one of the claims 3-6, wherein the at least one transistor comprises four transistors, wherein each of the four transistors couples with a distinct impedance shunted to the circuit ground or the low voltage rail, wherein each distinct impedance comprises a distinct fourth order, all-pole driving point impedance, each distinct impedance to receive the energy of the wireless communication signal during a different portion of the period of the carrier frequency of the wireless communication signal based on the set of clock pulses.

8. The apparatus of one of the previous claims, the second active impedance circuit comprising a negative inductance synthesized by a gyrator with differential mode positive feedback.

9. The apparatus of claim 8, wherein the second active impedance circuit comprises a negative resistance-capacitance amplifier circuit, wherein the negative resistance-capacitance amplifier circuit comprises a set of four transistors, wherein each of two of the set of four transistors comprises a parallel combination of a resistance and a capacitance coupled between a gate and a source of the transistor.

10. The apparatus of claim 9, wherein the second active impedance circuit comprises a bias transistor shunted to the circuit ground or a low voltage circuit rail to reduce distortion associated with amplifier circuitry of the second active impedance circuit.

11. The apparatus of any one of claim 1-10, wherein the first active impedance circuit comprises a first active impedance transistor coupled in parallel with a first capacitance, wherein the first active impedance transistor comprises a first resistance coupled between a source and a gate of the first active impedance transistor and a second capacitance coupled between the gate and a drain of the first active impedance transistor.

12. A system comprising:

receiver circuitry comprising an output, the receiver circuitry to apply, to the output, energy received via a wireless communication signal;
clock circuitry comprising a set of outputs, the clock circuitry to apply a different clock pulse of a set of clock pulses to each output of the set of outputs, wherein each clock pulse of the set of clock pulses has a duty cycle, wherein each clock pulse of the set of clock pulses has a period related to a period of a carrier frequency of the wireless communication signal;
a set of fourth order, all-pole driving point impedances, wherein each impedance comprises an input that is shunt to a circuit ground or a low voltage circuit rail via the impedance; and
a set of transistors, wherein each transistor of the set of transistors comprises a channel and a gate, wherein a first end of the channel is coupled with the output of the receiver circuitry to receive the energy, wherein a second end of the channel of each transistor of the set of transistors is coupled with the input of a different impedance of the set of fourth order, all-pole driving point impedances, wherein the gate of each transistor of the set of transistors is coupled with a different output of the set of outputs of the clock circuitry.

13. The system of claim 12, further comprising baseband shunt-feedback amplifiers coupled with the set of transistors to receive in-phase (I) and quadrature (Q) signals from the set of fourth order, all-pole driving point impedances.

14. An apparatus comprising:
a fourth order, all-pole driving point impedance, the impedance to shunt an input to a circuit ground via the impedance, wherein the impedance comprises:

a first active impedance circuit and

a second active impedance circuit coupled in series with the first active impedance circuit, the second active impedance circuit having a transfer function equivalent to a parallel combination of a negative resistance, a negative inductance, and a negative capacitance.

15. The apparatus of claim 14, wherein the first active impedance circuit comprises a first active impedance transistor coupled in parallel with a first capacitance, wherein the first active impedance transistor comprises a first resistance coupled between a source and a gate of the first active impedance transistor and a second capacitance coupled between the gate and a drain of the first active impedance transistor; wherein the second active impedance circuit comprises a negative inductance synthesized by a gyrator with differential mode positive feedback.

FIG. 1A

FIG. 1B

EP 4 535 663 A1

**FIG. 1C**

1032

0°

1030

1012

IN-PHASE
(I) OUTPUT
SIGNAL
1016

180°  $Z_4(s)$

90°  $Z_4(s)$

1014

270°  $Z_4(s)$

$Z_4(s)$

QUADRATURE
(Q) OUTPUT
SIGNAL
1018

1034

1007 TRANSISTORS

1006
N-PATH FILTER
CIRCUITRY

1008
BASEBAND
SHUNT-
FEEDBACK
AMPLIFIERS

EP 4 535 663 A1

**FIG. 1D**

OUTPUT SIGNAL TO BASEBAND AMPLIFIER
1008

INPUT SIGNAL FROM TRANSISTOR 1007 CHANNEL

1030

$Z_{2a}(s)$

$Z_{2b}(s)$

$Z_4(s)$

$R_1$   $C_1$   $g_m$   $C_S$   $R_2$   $C_2$   $-L_1$   $-R_1$   $-C_1$

**FIG. 1E**

$$Z_{in} = -2sL_1 = -2C_L/g_{m1,2}g_{m3,4}$$

FIG. 1F

$V_{Z2a(S)}$

1070

$V_{B1}$

$M_3$  $M_4$

$R_1(A-1)$  $R_1(A-1)$

$C_1/(A-1)$  $C_1/(A-1)$

$M_1$  $M_2$

$Z_{in} = -2(R_1 \| sC_1)$

$V_B$

1072

EP 4 535 663 A1

FIG. 1G

**FIG. 1H**

1085

M9: 10.40873MHz
2.97dB

M11: 50.0MHz
-40.85642dB

M12: 100.0MHz
-64.24297dB

EP 4 535 663 A1

AP MLD 210

WIRELESS COMMUNICATIONS I/F 216

PROCESSOR(S) 201

TSF TIMER 205

MEMORY 211

FRAME 212 STRUCTURES, ...

BASEBAND 218 PROCESSING CIRCUITRY

WIRELESS NETWORK INTERFACE 222

RADIO 224

N-PATH 225

FEM 226

ANT 228

200

NETWORK 280

MLD 230

WIRELESS COMMUNICATIONS I/F 246

PROCESSOR(S) 231

TSF TIMER 235

MEMORY 241

FRAME 242 STRUCTURES, ...

BASEBAND 248 PROCESSING CIRCUITRY

WIRELESS NETWORK INTERFACE 252

RADIO 254

N-PATH 255

FEM 256

ANT 258

MLD 290

MLD 292

MLD 294

MLD 296

MLD 298

FIG. 2A

RADIO ARCHITECTURE 2300
(SUCH AS WIRELESS INTERFACE
222 OR 252)

WIRELESS NIC 2302

WLAN FEM CIRCUITRY
2304A

N-PATH FILTER CIRCUITRY
2305A

SWITCH CIRCUITRY
2303

BT FEM CIRCUITRY
2304B

N-PATH FILTER CIRCUITRY
2305B

2301

WLAN RADIO IC CIRCUITRY
2306A

BT RADIO IC CIRCUITRY
2306B

WLAN - BT COEXIST CIRCUITRY
2313

WLAN BASEBAND PROCESSING CIRCUITRY
2308A

BT BASEBAND PROCESSING CIRCUITRY
2308B

IC 2312

APPLICATION PROCESSOR
2310

101

103

FIG. 2B

FIG. 2C

FIG. 2D

FIG. 2E

FIG. 2F

EP 4 535 663 A1

FIG. 2G

BASEBAND PROCESSING CIRCUITRY 2308A

RX BASEBAND PROCESSOR 2602

CONTROL LOGIC CIRCUITRY 2606

TX BASEBAND PROCESSOR 2604

ADC 2610

DAC 2612

RX 2507

TX 2511

FIG. 3

TRANSCEIVER 3000

RECEIVER 3004

STREAM DEPARSER 3066

FREQUENCY SEGMENT PARSER 3062

RECEIVE CHAINS

BASEBAND PROCESSING CIRCUITRY 3001

MAC LOGIC CIR 3091

PHY LOGIC CIR 3092

DECODER 3026

FREQ SEG DEPARSER 3027

DEINTER-LEAVER 3025

DEMOD 3024

OFDM 3022

STBC 3021 | DBF 3020

FFT 3019 | GI 3055

RADIO 3052

N-PATH FILTER CIR 3053

RX FEM 3050

LNA 3054

ANTENNA ARRAY 3018

WUR CIR 3120

TRANSMITTER 3006

WUR CIR 3110

ENCODER 3008

FREQ SEG PARSER 3007

INTER-LEAVER 3009

MOD 3010

OFDM 3012

STBC 3011 | DBF 3014

IFFT 3015 | GI 3045

RADIO 3042

TX FEM 3040

PA 3044

3016

3018

STREAM PARSER 3064

FREQUENCY SEGMENT DEPARSER 3060

PILOT INSERTION

TRANSMIT CHAINS

EP 4 535 663 A1

45

FIG. 4

4000

START

RECEIVE A WIRELESS COMMUNICATION SIGNAL AT ANTENNA — 4015

APPLY ENERGY RECEIVED VIA THE ANTENNA TO INPUT TRANSISTORS OF N-PATH FILTER CIRCUITRY — 4020

APPLY CLOCK PULSES TO GATES OF EACH OF THE INPUT TRANSISTORS, WHEREIN EACH CLOCK PULSE HAS A DUTY CYCLE, WHEREIN EACH CLOCK PULSE HAS A PERIOD TUNED TO A PERIOD OF A CARRIER FREQUENCY OF THE WIRELESS COMMUNICATION SIGNAL, WHEREIN EACH CLOCK PULSE IS DURING A DIFFERENT PORTION OF THE PERIOD OF THE CARRIER FREQUENCY — 4025

PASS ENERGY FROM THE WIRELESS COMMUNICATION SIGNAL THROUGH A CHANNEL OF ONE OF THE INPUT TRANSISTORS DURING EACH PORTION OF THE PERIOD OF THE CARRIER FREQUENCY BASED ON THE DUTY CYCLE OF THE CLOCK PULSES — 4030

SHUNT THE ENERGY TO GROUND FOR EACH DIFFERENT PORTION OF THE PERIOD OF THE CARRIER FREQUENCY VIA A DIFFERENT FOURTH ORDER, ALL-POLE DRIVING POINT IMPEDANCE COUPLED WITH THE CHANNELS OF THE INPUT TRANSISTORS — 4035

OUTPUT IN-PHASE AND QUADRATURE SIGNALS FROM THE FOURTH ORDER, ALL-POLE DRIVING POINT IMPEDANCES — 4040

PROCESS THE IN-PHASE AND QUADRATURE SIGNALS WITH BASEBAND SHUNT-FEEDBACK AMPLIFIERS — 4045

END

500

501

510

TRANSCEIVER

N-PATH FILTER CIRCUITRY 511

COMMUNICATIONS CIRCUITRY

502

MEMORY

508

506

PROCESSING CIRCUITRY

FIG. 5

FIG. 6

## FIG. 7

STORAGE MEDIUM 7000

COMPUTER
EXECUTABLE
INSTRUCTIONS FOR 7000

## FIG. 8

COMPUTING PLATFORM 8000

PROCESSING COMPONENT 8010

APPARATUS 8015

STORAGE MEDIUM 8020

OTHER PLATFORM COMPONENTS 8025

COMMUNICATIONS INTERFACE 8030

EP 4 535 663 A1

FIG. 9

PMC 912

BASEBAND CIRCUITRY 904

AUDIO DSP
904F

CPU
904E

MEMORY
904G

3G
BB
904A

4G
BB
904B

5G
BB
904C

OTHER
904D

APP
CIRCUITRY
902

RF CIRCUITRY 906

N-PATH FILTER
CIR 906E

MIX
906A

AMP
906B

FILTER
906C

SYNTH
906D

ANTENNA
910

FEM
908

FIG. 10A

COMMUNICATION CIRCUITRY

Protocol Processing Circuitry — 105

Digital Baseband Circuitry — 110

Transmit Circuitry — 115

Receive Circuitry — 120

Radio Frequency Circuitry — 125

Antenna Array — 130

100

FIG. 10B

RADIO FREQUENCY CIRCUITRY

Radio Chain Circuitry

N-path filter Circ

Radio Chain Circuitry

N-path filter Circ

Radio Chain Circuitry

N-path filter Circ

172    173

125

Power Combining & Dividing Circuitry — 174

176

178

EP 4 535 663 A1

FIG. 11

FIG. 12

BASEBAND CIRCUITRY 904

AUDIO DSP 904F

CPU 904E
MEM INT

MEMORY 904G

1204E

3G BB 904A — MEM INT — 1204A
4G BB 904B — MEM INT — 1204B
5G BB 904C — MEM INT — 1204C
OTHER 904D — MEM INT — 1204D

MEM INT — 1212
APP INT — 1214
RF INT — 1216
W-HW INT — 1218
PM INT — 1220

Europäisches
Patentamt

European
Patent Office

Office européen
des brevets

# EUROPEAN SEARCH REPORT

**Application Number**

EP 24 19 6076

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KRISHNAMURTHY SASHANK ET AL: "An Enhanced Mixer-First Receiver With Distortion Cancellation, Achieving 80-dB/decade RF Selectivity and +8-dBm B1dB for Adjacent Channel Blockers", IEEE SOLID-STATE CIRCUITS LETTERS, IEEE, vol. 4, 16 February 2021 (2021-02-16), pages 64-67, XP011843409, DOI: 10.1109/LSSC.2021.3059588 [retrieved on 2021-03-03] * page 64 - page 65; figures 1-8 * | 1-15 | INV. H03H19/00 |
| X | KRISHNAMURTHY SASHANK ET AL: "Synthesis and Design of Enhanced N-Path Filters With 60-dB/decade RF Selectivity", IEEE SOLID-STATE CIRCUITS LETTERS, IEEE, vol. 3, 3 November 2020 (2020-11-03), pages 522-525, XP011823458, DOI: 10.1109/LSSC.2020.3035962 [retrieved on 2020-11-30] * page 522 - page 523; figures 1-7 * | 1-15 | |

TECHNICAL FIELDS SEARCHED (IPC)

H03H

The present search report has been drawn up for all claims

| Place of search | Date of completion of the search | Examiner |
|---|---|---|
| Munich | 24 February 2025 | Mesplede, Delphine |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Carrier sense Multiple access with Collision Detection (CSMA/CD) Access Method and Physical Layer Specifications. *IEEE 802.3-2012*, December 2012

- *Infiniband Architecture Specification*, March 2015, vol. 1